# EUROPÄISCHE PATENTSCHRIFT

(11) **EP 3 714 531 B1**
(45) Veröffentlichungstag und Bekanntmachung des Hinweises auf die Patenterteilung: **10.03.2021**
(21) Anmeldenummer: 18827047.4
(22) Anmeldetag: 19.12.2018
(51) Int. Cl.: H02K 11/215, H02K 41/03, G01D 5/14, G01D 5/245, G01B 7/00, G01B 7/004

(54) **PLANARANTRIEBSSYSTEM, STATORMODUL UND SENSORMODUL**
PLANAR DRIVE SYSTEM, STATOR MODULE AND SENSOR MODULE
SYSTÈME D'ENTRAÎNEMENT PLANAIRE, MODULE DE STATOR ET MODULE DE CAPTEURS

(30) Priorität: 27.12.2017 DE 102017131320
(43) Veröffentlichungstag der Anmeldung: 30.09.2020
(73) Patentinhaber: Beckhoff Automation GmbH, 33415 Verl (DE)
(72) Erfinder: BENTFELD, Lukas, 33098 Paderborn (DE); PRUESSMEIER, Uwe, 32657 Lemgo (DE); BRINKMANN, Rolf, 32107 Bad Salzuflen (DE)
(74) Vertreter: Patentanwaltskanzlei WILHELM & BECK
(86) Internationale Anmeldenummer: PCT/EP2018/085772
(87) Internationale Veröffentlichungsnummer: WO 2019/129561

(56) Entgegenhaltungen:
- WO-A2-2009/083891
- JP-A- 2005 279 007
- US-A1- 2014 204 358

## Beschreibung

Die Erfindung betrifft ein Planarantriebssystem zum zwei- oder dreidimensionalen Antrieb eines Läufers, ein Statormodul für ein solches Planarantriebssystem und ein Sensormodul zur Erfassung einer Position des Läufers im Planarantriebssystem.

Planarantriebssysteme können unter anderem in der Automatisierungstechnik, insbesondere der Fertigungstechnik, der Handhabungstechnik und der Verfahrenstechnik eingesetzt werden. Mittels Planarantriebssystemen kann ein bewegliches Element einer Anlage oder Maschine in zwei oder drei linear unabhängigen Richtungen bewegt oder positioniert werden. Planarantriebssysteme können einen permanent erregten elektromagnetischen Planarmotor mit einem Planarstator und einem auf dem Planarstator in zwei oder drei Richtungen beweglichen Läufer umfassen.

Bei einem permanent erregten elektromagnetischen Planarmotor wird dadurch eine Antriebskraft auf den Läufer ausgeübt, dass Strom durchflossene Leiterschleifen mit an dem Läufer ausgebildeten Antriebsmagneten einer Magnetanordnung magnetisch wechselwirken.

Es kann vorgesehen sein, mittels einem Sensormodul eine Position des Läufers oberhalb des Planarstators zu ermitteln und die Bestromung der stromdurchflossenen Leiterschleifen anhand der ermittelten Positionen des Läufers zu variieren.

Das Sensormodul kann dabei Magnetfeldsensoren aufweisen, mit denen ein permanentes Magnetfeld des Läufers detektiert werden kann. Abhängig von der Position der Magnetfeldsensoren und des Läufers werden dann einzelne Magnetfeldsensoren ein magnetisches Feld messen und andere nicht. Betrachtet man die Signale aller Magnetfeldsensoren, können daraus Rückschlüsse über die Position des Läufers gezogen werden. Dabei können verschiedene Anordnungen der Magnetfeldsensoren innerhalb des Sensormoduls vorgesehen sein.

In der Druckschrift WO 2015/017933 A1 sind verschiedene Möglichkeiten für die Anordnung der Magnetfeldsensoren eines Sensormoduls zur Bestimmung einer Position eines Läufers offenbart. Dazu werden die Magnetfeldsensoren in einem periodischen Gitter angeordnet. Gitterkonstanten des periodischen Gitters können abhängig von Magnet-Arrays des Läufers gewählt werden, um eine Positionserfassung des Läufers zu ermöglichen. Die Magnetfeldsensoren können in Statormodule integriert werden, wobei die Statormodule eingerichtet sein können, neben der Positionserfassung auch Antriebsmittel für den Läufer bereitzustellen. Die in der Druckschrift WO 2015/017933 A1 offenbarten Zwischenräume zwischen den Magnetfeldsensoren sind jedoch relativ klein ausgebildet, so dass für den Betrieb des Statormoduls ebenfalls notwendige elektrische Anschlussleitungen und insbesondere Wärmeleitelemente zum Abtransport der beim Betrieb der Antriebsmittel entstehenden Abwärme nicht ohne Weiteres zwischen den Magnetfeldsensoren angeordnet werden können.

In der Druckschrift US 2014 / 204 358 A1 wird ein Planarantriebssystem mit einer Anordnung von Positionssensoren beschrieben.

In der Druckschrift JP 2005 279 007 A wird ein Lufthockey-Spiel offenbart, bei dem eine Anordnung von Positionssensoren zur Positionsbestimmung eines beweglichen Elements dient.

In der Druckschrift WO 2009 / 083 891 A2 ist ein pulsweitenmodulierter Verstärker für ein Planarantriebssystem offenbart.

Aufgabe der Erfindung ist es, ein verbessertes Sensormodul, ein Statormodul mit einem solchen verbesserten Sensormodul sowie ein Planarantriebssystem mit einem solchen verbesserten Sensormodul bereitzustellen.

Diese Aufgabe wird mit dem Planarantriebssystem, dem Statormodul und dem Sensormodul der unabhängigen Patentansprüche gelöst. Weiterbildungen sind in den abhängigen Patentansprüchen angegeben.

Ein Planarantriebssystem weist einen Läufer und ein Statormodul auf. Das Statormodul weist dabei ein Statormodulgehäuse, eine Statoreinheit für einen elektrischen Antrieb des Läufers und ein Sensormodul zur Erfassung einer Position des Läufers auf. Der Läufer ist über einer ebenen Statoroberfläche der Statoreinheit zumindest in einer ersten Richtung und in einer zweiten Richtung, die linear unabhängig sind, antreibbar. Es kann zusätzlich vorgesehen sein, dass der Läufer in einer dritten Richtung senkrecht zur ersten beziehungsweise zweiten Richtung ebenfalls antreibbar ist. Das Sensormodul weist einen Träger und eine zweidimensionale Anordnung von Magnetfeldsensoren auf. Die Magnetfeldsensoren sind auf dem Träger angeordnet. Die zweidimensionale Anordnung von Magnetfeldsensoren weist eine erste Teilanordnung von Magnetfeldsensoren und eine zweite Teilanordnung von Magnetfeldsensoren auf. Die Magnetfeldsensoren der ersten Teilanordnung sind in einem ersten periodischen Gitter angeordnet. Die Magnetfeldsensoren im ersten periodischen Gitter sind entlang der ersten Richtung und entlang der zweiten Richtung angeordnet. Benachbarte Magnetfeldsensoren der ersten Teilanordnung in der ersten Richtung sind in einem ersten Abstand zueinander angeordnet. Benachbarte Magnetfeldsensoren der ersten Teilanordnung in der zweiten Richtung sind in einem zweiten Abstand zueinander angeordnet. Die Magnetfeldsensoren der zweiten Teilanordnung sind in einem zweiten periodischen Gitter angeordnet. Die Magnetfeldsensoren im zweiten periodischen Gitter sind entlang der ersten Richtung und entlang der zweiten Richtung angeordnet. Benachbarte Magnetfeldsensoren der zweiten Teilanordnung sind in der ersten Richtung im ersten Abstand zueinander angeordnet und in der zweiten Richtung im zweiten Abstand zueinander angeordnet. Die erste Teilanordnung und die zweite Teilanordnung sind zueinander um einen Vektor verschoben angeordnet. Der Vektor weist eine erste Komponente in der ersten Richtung und eine zweite Komponente in der zweiten Richtung auf. Die erste Komponente ist kleiner als der erste Abstand. Die zweite Komponente ist kleiner als der zweite Abstand.

Der Läufer weist eine erste Magneteinheit mit einer ersten periodischen Anordnung von Magneten mit einer ersten Periodenlänge auf. Ferner weist der Läufer eine zweite Magneteinheit mit einer zweiten periodischen Anordnung von Magneten mit einer zweiten Periodenlänge auf. Die erste periodische Anordnung von Magneten ist in der ersten Richtung periodisch. Die zweite Anordnung von Magneten ist in der zweiten Richtung periodisch. Während des Betriebs des Planarantriebssystems ist die erste Magneteinheit in der ersten Richtung ausgerichtet und die zweite Magneteinheit in der zweiten Richtung ausgerichtet. Die erste Komponente ist kleiner als die erste Periodenlänge. Eine Differenz aus dem ersten Abstand und der ersten Komponente ist ebenfalls kleiner als die erste Periodenlänge. Die zweite Komponente ist kleiner als die zweite Periodenlänge. Eine Differenz aus dem zweiten Abstand und der zweiten Komponente ist ebenfalls kleiner als die zweite Periodenlänge. Die Statoreinheit ist an einer Oberseite des Statormodulgehäuses angeordnet. Der Träger ist unterhalb der Statoreinheit im Statormodulgehäuse angeordnet, wobei der Träger eine Durchgangsöffnung aufweist. Das Statormodulgehäuse weist ferner eine Wärmeleitstruktur auf, die eingerichtet ist, Wärme von der Statoreinheit weg zu einer der Statoroberfläche gegenüberliegenden Unterseite des Statormodulgehäuses zu leiten. Die Wärmeleitstruktur ist von der Statoreinheit durch die Durchgangsöffnung zur Unterseite des Statormodulgehäuses geführt. Die Durchgangsöffnung grenzt an vier Magnetfeldsensoren an, wobei davon jeweils zwei erste Magnetfeldsensoren zur ersten Teilanordnung und jeweils zwei zweite Magnetfeldsensoren zur zweiten Teilanordnung zugeordnet sind.

Um die Position des Läufers im Planarantriebssystem zu erfassen, ist es notwendig, dass eine genügend große Anzahl von Magnetfeldsensoren innerhalb des Sensormoduls vorgesehen ist. Dadurch ist es möglich, dass immer eine genügende Anzahl von Magnetfeldsensoren in einer Umgebung des Läufers zur Verfügung stehen, um eine genaue Position des Läufers ermitteln zu können. Andererseits müssen die Messdaten der Magnetfeldsensoren ausgewertet werden, weswegen eine möglichst geringe Anzahl von Magnetfeldsensoren vorgesehen werden soll, da dadurch eine benötigte Rechenleistung verringert werden kann. Mit der erfindungsgemäßen Anordnung der Magnetfeldsensoren der Positionserfassungseinheit in zwei periodischen Gittern, wobei die Gitter identisch aufgebaut und zueinander verschoben sind, werden einerseits genügend Magnetfeldsensoren bereitgestellt, um die Position des Läufers zu erfassen. Andererseits ist die Anzahl der Magnetfeldsensoren geringer als bisher im Stand der Technik bekannt, sodass die benötige Rechenleistung bei der Auswertung während der Erfassung der Position des Läufers verringert werden kann.

In einer Ausführungsform ist die erste Periodenlänge ein Produkt aus einer ersten rationalen Zahl und dem ersten Abstand und die zweite Periodenlänge ein Produkt aus einer zweiten rationalen Zahl und dem zweiten Abstand. Die erste rationale Zahl und die zweite rationale Zahl sind aus einem Intervall zwischen 0,5 und 1.

In einer Ausführungsform ist der Zähler der ersten rationalen Zahl und/oder der Zähler der zweiten rationalen Zahl ungerade.

In einer Ausführungsform beträgt die erste rationale Zahl fünf Sechstel. Ferner beträgt die zweite rationale Zahl fünf Sechstel. Dadurch wird einerseits eine ausreichende Anzahl von Magnetfeldsensoren zur Erfassung der Position der Magneteinheiten bereitgestellt und andererseits eine geringstmögliche Zahl von Magnetfeldsensoren vorgesehen.

Es kann vorgesehen sein, dass die Statoreinheit bestrombare Leiterstreifen aufweist. Die bestrombaren Leiterstreifen können so bestromt werden, dass durch die Bestromung der Leiterstreifen erzeugte Magnetfelder mit den Magneteinheiten des Läufers wechselwirken und somit den Läufer antreiben. Die Leiterstreifen können im Wesentlichen entlang der ersten Richtung beziehungsweise entlang der zweiten Richtung angeordnet sein. Zwei benachbarte Leiterstreifen, die entlang der ersten Richtung angeordnet sind, weisen einen ersten Leiterstreifenabstand in der zweiten Richtung auf, wobei der erste Leiterstreifenabstand als Entfernung zwischen zwei Mittellinien der entlang der ersten Richtung ausgerichteten Leiterstreifen definiert ist. Mit diesen Leiterstreifen kann der Läufer in die erste Richtung angetrieben werden. Zwei benachbarte Leiterstreifen, die entlang der zweiten Richtung angeordnet sind, weisen einen zweiten Leiterstreifenabstand in der ersten Richtung auf, wobei der zweite Leiterstreifenabstand als Entfernung zwischen zwei Mittellinien der entlang der zweiten Richtung ausgerichteten Leiterstreifen definiert ist. Mit diesen Leiterstreifen kann der Läufer in die zweite Richtung angetrieben werden. Es kann vorgesehen sein, sowohl entlang der ersten Richtung als auch entlang der zweiten Richtung ausgerichtete Leiterstreifen vorzusehen. Dann kann der Läufer sowohl in die erste als auch in die zweite Richtung angetrieben werden. Der erste Abstand beziehungsweise der zweite Abstand können sechsunddreißig Fünftel des ersten beziehungsweise zweiten Leiterstreifenabstands betragen. Durch diese Relation von Leiterstreifenabstand und Abstand der Magnetfeldsensoren ergibt sich eine Statoreinheit, die sowohl gut zum Antrieb des Läufers als auch zur Ermittlung der Position des Läufers geeignet ist.

In einer Ausführungsform beträgt die erste Komponente zwischen 0,35 und 0,65 des ersten Abstands. Die zweite Komponente beträgt zwischen 0,35 und 0,65 des zweiten Abstands.

Eine solche Verschiebung des ersten Gitters der ersten Teilanordnung und des zweiten Gitters der zweiten Teilanordnung zueinander ermöglicht eine flächendeckende Abdeckung des Sensormoduls mit Magnetfeldsensoren. Die Magnetfeldsensoren des zweiten Gitters sind dabei in einem Mittenbereich zwischen den Magnetfeldsensoren des ersten Gitters angeordnet.

In einer Ausführungsform entspricht die erste Komponente dem halben ersten Abstand und die zweite Komponente dem halben zweiten Abstand. Wenn beide Komponenten dem jeweiligen halben Abstand entsprechen, sind die Magnetfeldsensoren der zweiten Teilanordnung exakt in der Mitte zwischen den Magnetfeldsensoren der ersten Teilanordnung angeordnet. Dadurch wird die Positionserfassung des Läufers weiter verbessert. Ferner wird durch die Anordnung der Magnetfeldsensoren des zweiten Gitters exakt mittig zwischen den Magnetfeldsensoren des ersten Gitters ein Zwischenraum zwischen Magnetfeldsensoren maximiert. In diesem Zwischenraum können dann einfacher Wärmeleitelemente vorgesehen werden.

In einer Ausführungsform sind der erste Abstand und der zweite Abstand gleich groß. Dies bedeutet zusätzlich, dass die erste Periodenlänge der ersten Magneteinheit des Läufers identisch ist zur zweiten Periodenlänge der zweiten Magneteinheit des Läufers. Dadurch wird eine regelmäßige Anordnung der Magnetfeldsensoren möglich, mit der die Positionserfassung weiter verbessert werden kann.

In einer Ausführungsform stehen die erste Richtung und die zweite Richtung senkrecht zueinander. Dadurch kann das Planarantriebssystem so eingerichtet werden, dass der Läufer sowohl in eine x-Richtung als auch in eine y-Richtung bewegt werden kann, wobei x- Richtung der ersten Richtung und die y-Richtung der zweiten Richtung entsprechen können. Ferner kann der Läufer auch gleichzeitig in der x- und der y-Richtung angetrieben werden. Darüber hinaus ist auch in geringem Maße ein Antrieb des Läufers in einer dritten Richtung senkrecht zur ersten Richtung und zur zweiten Richtung möglich. Wenn die Magneteinheiten des Läufers rechteckig ausgeführt sind, kann dadurch eine kompakte Anordnung der Magneteinheit innerhalb des Läufers erreicht werden.

In einer Ausführungsform ist die Statoroberfläche ein Parallelogramm. Eine Länge einer ersten Parallelogrammseite der Statoroberfläche ist ein erstes ganzzahliges Vielfaches des ersten Abstands, eine Länge einer zweiten Parallelogrammseite der Statoroberfläche ist ein zweites ganzzahliges Vielfaches des zweiten Abstands. Die erste Parallelogrammseite ist parallel zur ersten Richtung ausgerichtet. Die zweite Parallelogrammseite ist parallel zur zweiten Richtung ausgerichtet.

Dadurch können mehrere Statormodule direkt aneinander angrenzend angeordnet werden, wobei die Magnetfeldsensoren der ersten Teilanordnungen der Statormodule jeweils eine erste Teilanordnung von Magnetfeldsensoren über alle Statormodule bilden und die zweiten Teilanordnungen der Magnetfeldsensoren der Statormodule eine zweite Teilanordnung von Magnetfeldsensoren über alle Statormodule bilden. Das Gitter der ersten Teilanordnung und das Gitter der zweiten Teilanordnung kann also mittels Anbringen eines nächsten Statormoduls direkt an ein Statormodul angrenzend fortgesetzt werden. Somit entsteht eine einfache Möglichkeit, ein Planarantriebssystem modular aus mehreren Statormodulen aufzubauen, wobei die Magnetfeldsensoren der Sensormodule ein durchgängiges Gitter über die gesamte Oberfläche der Statormodule bilden.

Dadurch wird die Positionserfassung des Läufers in einem modular aufgebauten Planarantriebssystem wesentlich vereinfacht.

In einer Ausführungsform ist das Statormodul rechteckig. Wenn das Statormodul rechteckig ist, können mehrere Statormodule noch einfacher modular aneinander angrenzend angeordnet werden. In einer Ausführungsform ist das Statormodul quadratisch.

In einer Ausführungsform sind das erste ganzzahlige Vielfache und das zweite ganzzahlige Vielfache identisch. Dies bedeutet, dass jedes Statormodul in der ersten Richtung und in der zweiten Richtung eine identische Anzahl von Magnetfeldsensoren innerhalb des Gitters der ersten Teilanordnung und innerhalb des Gitters der zweiten Teilanordnung aufweist.

In einer Ausführungsform ist der Träger derart angeordnet, dass ein erster Magnetfeldsensor der ersten Teilanordnung unter einem ersten Eckbereich der Statoroberfläche angeordnet ist. Der erste Eckbereich der Statoroberfläche ist dabei an einem Schnittpunkt von erster Parallelogrammseite und zweiter Parallelogrammseite angeordnet. Der erste Magnetfeldsensor ist in der ersten Richtung um ein Viertel des ersten Abstands von der zweiten Parallelogrammseite entfernt angeordnet. Eine Magnetfeldsensorebene, die die Magnetfeldsensoren enthält, schneidet eine erste Ebene, die die zweite Parallelogrammseite enthält und die senkrecht auf der Magnetfeldsensorebene steht. Dass der erste Magnetfeldsensor in der ersten Richtung um ein Viertel des ersten Abstands von der zweiten Parallelogrammseite entfernt angeordnet ist, soll bedeuten, dass ein Vektor parallel zur ersten Richtung vom ersten Magnetfeldsensor zur Schnittgerade von Magnetfeldsensorebene und erster Ebene eine Länge von einem Viertel des ersten Abstands aufweist. In der zweiten Richtung ist der erste Magnetfeldsensor um ein Viertel des zweiten Abstands von der ersten Parallelogrammseite entfernt angeordnet. Die Magnetfeldsensorebene schneidet eine zweite Ebene, die die erste Parallelogrammseite enthält und die senkrecht auf der Magnetfeldsensorebene steht. Dass der erste Magnetfeldsensor in der zweiten Richtung um ein Viertel des zweiten Abstands von der ersten Parallelogrammseite entfernt angeordnet ist, soll bedeuten, dass ein Vektor parallel zur zweiten Richtung vom ersten Magnetfeldsensor zur Schnittgerade von Magnetfeldsensorebene und zweiter Ebene eine Länge von einem Viertel des zweiten Abstands aufweist.

Ein zweiter Magnetfeldsensor der zweiten Teilanordnung ist unter einem dem ersten Eckbereich gegenüberliegenden zweiten Eckbereich der Statoroberfläche angeordnet. Der zweite Eckbereich der Statoroberfläche ist dabei an einem Schnittpunkt von einer dritten Parallelogrammseite und einer vierten Parallelogrammseite angeordnet. Der zweite Magnetfeldsensor ist in der ersten Richtung um ein Viertel des ersten Abstands von der vierten Parallelogrammseite des Statormoduls entfernt angeordnet, wobei die vierte Parallelogrammseite der zweiten Parallelogrammseite gegenüberliegt. Die Magnetfeldsensorebene schneidet eine dritte Ebene, die die vierte Parallelogrammseite enthält und die senkrecht auf der Magnetfeldsensorebene steht. Dass der zweite Magnetfeldsensor in der ersten Richtung um ein Viertel des ersten Abstands von der vierten Parallelogrammseite entfernt angeordnet ist, soll bedeuten, dass ein Vektor parallel zur ersten Richtung vom zweiten Magnetfeldsensor zur Schnittgerade von Magnetfeldsensorebene und dritter Ebene eine Länge von einem Viertel des ersten Abstands aufweist. Der zweite Magnetfeldsensor ist in der zweiten Richtung um ein Viertel des zweiten Abstands von der dritten Parallelogrammseite des Statormoduls entfernt angeordnet, wobei die dritte Parallelogrammseite der ersten Parallelogrammseite gegenüberliegt. Die Magnetfeldsensorebene schneidet eine vierte Ebene, die die dritte Parallelogrammseite enthält und die senkrecht auf der Magnetfeldsensorebene steht. Dass der zweite Magnetfeldsensor in der zweiten Richtung um ein Viertel des zweiten Abstands von der dritten Parallelogrammseite entfernt angeordnet ist, soll bedeuten, dass ein Vektor parallel zur zweiten Richtung vom zweiten Magnetfeldsensor zur Schnittgerade von Magnetfeldsensorebene und vierter Ebene eine Länge von einem Viertel des zweiten Abstands aufweist.

Dadurch bilden die Magnetfeldsensoren der ersten Teilanordnung und der zweiten Teilanordnung zusammen eine in sich punktsymmetrische Anordnung von Magnetfeldsensoren. Dadurch kann das Statormodul um 180° gedreht werden, wobei sich dabei die Anordnung der Magnetfeldsensoren nicht ändert, da durch die Drehung die Magnetfeldsensoren der ersten Teilanordnung die Positionen der Magnetfeldsensoren der zweiten Teilanordnung vor der Drehung annehmen und umgekehrt. Dies ermöglicht die Bereitstellung von Statormodulen, die noch flexibler eingesetzt werden können.

In einer Ausführungsform weist die erste Magneteinheit in der ersten Richtung eine erste Ausdehnung auf, die der ersten Periodenlänge entspricht. Ferner weist die erste Magneteinheit in der zweiten Richtung eine zweite Ausdehnung auf, die dem Doppelten der zweiten Periodenlänge entspricht. Die zweite Magneteinheit weist in der zweiten Richtung eine dritte Ausdehnung auf, die der zweiten Periodenlänge entspricht. Ferner weist die zweite Magneteinheit in der ersten Richtung eine vierte Ausdehnung auf, die dem Doppelten der ersten Periodenlänge entspricht.

In einer Ausführungsform weist der Läufer eine dritte Magneteinheit und eine vierte Magneteinheit auf. Die dritte Magneteinheit umfasst eine dritte periodische Anordnung von Magneten, welche in der ersten Richtung periodisch ist, und deren Periodenlänge der ersten Periodenlänge entspricht. Die dritte Magneteinheit ist während des Betriebs des Planarantriebssystems in der ersten Richtung ausgerichtet. Die erste Magneteinheit und die dritte Magneteinheit sind in einem ersten Magneteinheitenabstand voneinander entfernt angeordnet. Die vierte Magneteinheit weist eine vierte periodische Anordnung von Magneten, die in der zweiten Richtung periodisch ist, und deren Periodenlänge der zweiten Periodenlänge entspricht, auf. Die vierte Magneteinheit ist während des Betriebs des Planarantriebssystems in der zweiten Richtung ausgerichtet. Die zweite Magneteinheit und die vierte Magneteinheit sind in einem zweiten Magneteinheitenabstand zueinander angeordnet. Die dritte Magneteinheit weist in der ersten Richtung die erste Ausdehnung auf. Die dritte Magneteinheit weist in der zweiten Richtung die zweite Ausdehnung auf. Die vierte Magneteinheit weist in der zweiten Richtung die dritte Ausdehnung auf. Die vierte Magneteinheit weist in der ersten Richtung die vierte Ausdehnung auf.

Die Magneteinheiten sind in einem Quadrat angeordnet. Die erste Magneteinheit ist in einer ersten Ecke des Quadrats angeordnet. Die zweite Magneteinheit ist in einer zweiten Ecke des Quadrats angeordnet. Die dritte Magneteinheit ist in einer dritten Ecke des Quadrats angeordnet. Die vierte Magneteinheit ist in einer vierten Ecke des Quadrats angeordnet. Die erste Ecke ist gegenüber der dritten Ecke angeordnet.

Dadurch wird ein kompakter Läufer, dessen Position mittels des Sensormoduls ermittelt werden kann, bereitgestellt.

In einer Ausführungsform entspricht der erste Magneteinheitenabstand der ersten Periodenlänge oder dreizehn Zwölftel der ersten Periodenlänge. In einer Ausführungsform entspricht der zweite Magneteinheitenabstand der zweiten Periodenlänge oder dreizehn Zwölftel der zweiten Periodenlänge.

In einer Ausführungsform sind die erste Magneteinheit und die zweite Magneteinheit rechteckig ausgeführt. In einer Ausführungsform sind die dritte und die vierte Magneteinheit ebenfalls rechteckig ausgeführt.

Wenn die erste Periodenlänge fünf Sechstel des ersten Abstands und die zweite Periodenlänge fünf Sechstel des zweiten Abstands beträgt, und jeweils zwei zueinander parallele Magneteinheiten innerhalb des Läufers vorgesehen sind, die jeweils im Abstand von der ersten Periodenlänge oder dreizehn Zwölftel der ersten Periodenlänge beziehungsweise der zweiten Periodenlänge oder dreizehn Zwölftel der zweiten Periodenlänge voneinander entfernt angeordnet sind, wird eine gute Positionserfassung des Läufers ermöglicht.

Ein Statormodul für ein Planarantriebssystem weist ein Statormodulgehäuse und eine Statoreinheit für einen elektrischen Antrieb eines Läufers und ein Sensormodul auf. Der Läufer ist über einer ebenen Statoroberfläche der Statoreinheit zumindest in einer ersten Richtung und in einer zweiten Richtung antreibbar. Das Sensormodul weist einen Träger und eine zweidimensionale Anordnung von Magnetfeldsensoren auf. Die Magnetfeldsensoren sind auf dem Träger angeordnet. Die zweidimensionale Anordnung von Magnetfeldsensoren weist eine erste Teilanordnung von Magnetfeldsensoren und eine zweite Teilanordnung von Magnetfeldsensoren auf. Die Magnetfeldsensoren der ersten Teilanordnung sind in einem ersten periodischen Gitter angeordnet. Innerhalb des ersten periodischen Gitters sind die Magnetfeldsensoren entlang einer ersten Richtung und entlang einer zweiten Richtung angeordnet. Benachbarte Magnetfeldsensoren der ersten Teilanordnung in der ersten Richtung sind in einem ersten Abstand zueinander angeordnet. Benachbarte Magnetfeldsensoren der ersten Teilanordnung sind in der zweiten Richtung in einem zweiten Abstand zueinander angeordnet. Die Magnetfeldsensoren der zweiten Teilanordnung sind in einem zweiten periodischen Gitter angeordnet. Die Magnetfeldsensoren sind im zweiten periodischen Gitter entlang der ersten Richtung und entlang der zweiten Richtung angeordnet. Benachbarte Magnetfeldsensoren der zweiten Teilanordnung sind in der ersten Richtung im ersten Abstand zueinander und in der zweiten Richtung im zweiten Abstand zueinander angeordnet. Die erste Teilanordnung und die zweite Teilanordnung sind zueinander um einen Vektor verschoben angeordnet, wobei dieser Vektor eine erste Komponente in einer Richtung und eine zweite Komponente in der zweiten Richtung aufweist. Die erste Komponente ist kleiner als der erste Abstand und die zweite Komponente ist kleiner als der zweite Abstand. Die Statoreinheit ist an einer Oberseite des Statormodulgehäuses angeordnet. Der Träger ist unterhalb der Statoreinheit im Statormodulgehäuse angeordnet, wobei der Träger eine Durchgangsöffnung aufweist. Das Statormodulgehäuse weist ferner eine Wärmeleitstruktur auf, die eingerichtet ist, Wärme von der Statoreinheit weg zu einer der Statoroberfläche gegenüberliegenden Unterseite des Statormodulgehäuses zu leiten. Die Wärmeleitstruktur ist von der Statoreinheit durch die Durchgangsöffnung zur Unterseite des Statormodulgehäuses geführt. Die Durchgangsöffnung grenzt an vier Magnetfeldsensoren an, wobei davon jeweils zwei erste Magnetfeldsensoren zur ersten Teilanordnung und jeweils zwei zweite Magnetfeldsensoren zur zweiten Teilanordnung zugeordnet sind. Die Anordnung der Magnetfeldsensoren innerhalb des Statormoduls entspricht also der Anordnung der Magnetfeldsensoren des Statormoduls des Planarantriebssystems.

Die Statoreinheit sollte möglichst nahe an der Oberseite angeordnet werden, um den Läufer effektiv antreiben zu können. Das Sensormodul sollte einerseits in einem gewissen Abstand zur Oberseite angeordnet werden, um eine Signalsättigung der Magnetfeldsensoren zu vermeiden. Andererseits sollte das Sensormodul in keinem zu großen Abstand von der Oberseite angeordnet sein, um ein Signal messen zu können. Aus diesem Grund kann es notwendig sein, die bei einem Betrieb der Statoreinheit entstehende Wärme, die durch die hohen Ströme verursacht wird, welche für den Antrieb nötig sind, von der Statoreinheit wegzuleiten. Dies kann über Wärmeleitelemente geschehen, welche durch Durchgangsöffnungen durch den Träger des Sensormoduls geführt sind. Die erfindungsgemäße Anordnung der Magnetfeldsensoren in zwei Teilanordnungen ermöglicht dabei, relativ große Durchgangsöffnungen vorzusehen, wodurch die Wärmeleitfähigkeit verbessert werden kann. Ein Zwischenraum zwischen vier Magnetfeldsensoren kann zum Durchführen einer Wärmeleitstruktur genutzt werden. Dieser Zwischenraum befindet sich zwischen zwei Magnetfeldsensoren der ersten Teilanordnung und zwei Magnetfeldsensoren der zweiten Teilanordnung.

In einer Ausführungsform ist der Träger innerhalb des Statormodulgehäuses angeordnet.

In einer Ausführungsform beträgt die erste Komponente zwischen 0,35 und 0,65 des ersten Abstands. Die zweite Komponente beträgt zwischen 0,35 und 0,65 des zweiten Abstands. In einer Ausführungsform entspricht die erste Komponente dem halben ersten Abstand und die zweite Komponente dem halben zweiten Abstand. In einer Ausführungsform stehen die erste Richtung und die zweite Richtung senkrecht zueinander.

In einer Ausführungsform ist die Statoroberfläche ein Parallelogramm. Eine Länge einer ersten Parallelogrammseite der Statoroberfläche ist ein erstes ganzzahliges Vielfaches des ersten Abstands. Eine Länge einer zweiten Parallelogrammseite der Statoroberfläche ist ein zweites ganzzahliges Vielfaches des zweiten Abstands.

In einer Ausführungsform ist das Statormodul rechteckig. In einer Ausführungsform ist das Statormodul quadratisch. In einer Ausführungsform sind das erste ganzzahlige Vielfache und das zweite ganzzahlige Vielfache identisch.

In einer Ausführungsform ist der Träger im Statormodul derart angeordnet, dass ein erster Magnetfeldsensor der ersten Teilanordnung unterhalb eines ersten Eckbereichs der Statoroberfläche angeordnet ist. Der erste Eckbereich ist dabei an einem Schnittpunkt von erster und zweiter Parallelogrammseite angeordnet. Der erste Magnetfeldsensor ist in der ersten Richtung um ein Viertel des ersten Abstands von der zweiten Parallelogrammseite der Statoroberfläche entfernt angeordnet. Der erste Magnetfeldsensor ist in der zweiten Richtung um ein Viertel des zweiten Abstands von der ersten Parallelogrammseite der Statoroberfläche entfernt angeordnet. Ein zweiter Magnetfeldsensor der zweiten Teilanordnung ist unterhalb eines zweiten Eckbereichs der Statoroberfläche angeordnet. Der zweite Eckbereich ist dabei an einem Schnittpunkt von einer dritten und einer vierten Parallelogrammseite der Statoroberfläche angeordnet. Der zweite Magnetfeldsensor ist in der ersten Richtung um ein Viertel des ersten Abstands von der vierten Parallelogrammseite des Statormoduls entfernt angeordnet. Die vierte Parallelogrammseite liegt dabei der zweiten Parallelogrammseite gegenüber. Der zweite Magnetfeldsensor ist in der zweiten Richtung um ein Viertel des zweiten Abstands von der dritten Parallelogrammseite des Statormoduls entfernt angeordnet. Die dritte Parallelogrammseite liegt der ersten Parallelogrammseite gegenüber.

Dadurch sind die Magnetfeldsensoren des Statormoduls wiederum so im Statormodul angeordnet, dass die Position der Magnetfeldsensoren invariant bei einer Drehung von 180° des Statormoduls um eine Hochachse ist, wobei die Hochachse durch den Mittelpunkt des Statormoduls verläuft. Dadurch wird ein einfacherer modularer Aufbau des Planarantriebssystems ermöglicht, da die Statormodule sowohl in ursprünglicher Orientierung als auch in 180° gedrehter Orientierung aneinander anreihbar sind und das periodische Gitter der Magnetfeldsensoren stetig fortgesetzt wird.

In einer Ausführungsform sind der erste Abstand und der zweite Abstand gleich groß.

In einer Ausführungsform sind die Magnetfeldsensoren Hall-Sensoren und insbesondere zweidimensionale oder dreidimensionale Hall-Sensoren, im Folgenden auch als 2D- oder 3D-Hall-Sensoren bezeichnet. Hall-Sensoren, 2D-Hall-Sensoren und 3D-Hall-Sensoren stellen eine einfache Möglichkeit dar, Magnetfeldsensoren zu realisieren.

In einer Ausführungsform weist der Träger eine Leiterplatte, insbesondere eine Platine, auf. Dadurch können einfache Fertigungstechniken zur Bereitstellung des Sensormoduls, das den Träger mit den darauf angeordneten Magnetfeldsensoren beinhaltet, realisiert werden.

In einer Ausführungsform weist der Träger mehrere Durchgangsöffnungen und mehrere durch die Durchgangsöffnungen geführte Wärmeleitelemente auf. Die Durchgangsöffnungen grenzen jeweils an vier Magnetfeldsensoren an, wobei davon jeweils zwei Magnetfeldsensoren zur ersten Teilanordnung und jeweils zwei Magnetfeldsensoren zur zweiten Teilanordnung zugeordnet sind. Dadurch kann die Wärmeleitung von der Statoreinheit zur Unterseite weiter verbessert werden.

In einer Ausführungsform sind eine oder mehrere Durchgangsöffnungen viereckig und/oder fünfeckig. In einer Ausführungsform weist der Träger einen inneren Bereich und einen äußeren Bereich auf. Der äußere Bereich ist ringförmig um den inneren Bereich angeordnet. Die Durchgangsöffnung oder die Durchgangsöffnungen sind im äußeren Bereich angeordnet. Der innere Bereich umfasst maximal 35 Prozent der Fläche des Sensormoduls. Mit einer solchen Anordnung können mehrere Wärmeleitelemente durch Durchgangsöffnungen durch den äußeren ringförmigen Bereich geführt werden. Dies ermöglicht, die Abwärme der Statoreinheit nahezu vollständig von der Statoreinheit weg zur Unterseite des Gehäuses zu leiten.

In einer Ausführungsform umfasst die Anordnung von Magnetfeldsensoren genau zwei Teilanordnungen von Magnetfeldsensoren.

Es kann vorgesehen sein, dass die Statoreinheit bestrombare Leiterstreifen aufweist. Die bestrombaren Leiterstreifen können so bestromt werden, dass durch die Bestromung der Leiterstreifen induzierte Magnetfelder mit den Magneteinheiten des Läufers wechselwirken und somit den Läufer antreiben. Die Leiterstreifen können im Wesentlichen entlang der ersten Richtung beziehungsweise entlang der zweiten Richtung angeordnet sein. Zwei benachbarte Leiterstreifen, die entlang der ersten Richtung angeordnet sind, weisen einen ersten Leiterstreifenabstand in der zweiten Richtung auf, wobei der erste Leiterstreifenabstand als Entfernung zwischen zwei Mittellinien der entlang der ersten Richtung ausgerichteten Leiterstreifen definiert ist. Zwei benachbarte Leiterstreifen, die entlang der zweiten Richtung angeordnet sind, weisen einen zweiten Leiterstreifenabstand in der ersten Richtung auf, wobei der zweite Leiterstreifenabstand als Entfernung zwischen zwei Mittellinien der entlang der zweiten Richtung ausgerichteten Leiterstreifen definiert ist. Der erste Abstand beziehungsweise der zweite Abstand können sechsunddreißig Fünftel des ersten beziehungsweise zweiten Leiterstreifenabstands betragen. Durch diese Relation von Leiterstreifenabstand und Abstand der Magnetfeldsensoren ergibt sich eine Statoreinheit, die sowohl gut zum Antrieb des Läufers als auch zur Ermittlung der Position des Läufers geeignet ist.

Die weiteren Ausgestaltungen des Statormoduls können im Statormodul des Planarantriebssystems ebenfalls verwendet werden.

Ein Sensormodul zur Erfassung einer Position eines Läufers in einem Planarantriebssystem umfasst einen Träger und eine zweidimensionale Anordnung von Magnetfeldsensoren. Die Magnetfeldsensoren sind auf dem Träger angeordnet. Die zweidimensionale Anordnung von Magnetfeldsensoren weist eine erste Teilanordnung von Magnetfeldsensoren und eine zweite Teilanordnung von Magnetfeldsensoren auf. Die Magnetfeldsensoren der ersten Teilanordnung sind in einem ersten periodischen Gitter in einer ersten Richtung und einer zweiten Richtung angeordnet. Benachbarte Magnetfeldsensoren der ersten Teilanordnung sind in der ersten Richtung in einem ersten Abstand zueinander angeordnet. Benachbarte Magnetfeldsensoren der ersten Teilanordnung sind in der zweiten Richtung in einem zweiten Abstand zueinander angeordnet. Die Magnetfeldsensoren der zweiten Teilanordnung sind in einem zweiten periodischen Gitter angeordnet, wobei die Magnetfeldsensoren im zweiten periodischen Gitter in der ersten Richtung und in der zweiten Richtung angeordnet sind. Benachbarte Magnetfeldsensoren der zweiten Teilanordnung sind in der ersten Richtung im ersten Abstand zueinander angeordnet und in der zweiten Richtung im zweiten Abstand zueinander angeordnet. Die erste Teilanordnung und die zweite Teilanordnung sind zueinander um einen Vektor verschoben, wobei der Vektor eine erste Komponente der ersten Richtung und eine zweite Komponente in der zweiten Richtung aufweist. Die erste Komponente ist kleiner als der erste Abstand und die zweite Komponente ist kleiner als der zweite Abstand. Der Träger weist eine Durchgangsöffnung für eine Wärmeleitstruktur auf, wobei die Durchgangsöffnung an vier Magnetfeldsensoren angrenzt. Davon sind jeweils zwei erste Magnetfeldsensoren zur ersten Teilanordnung und jeweils zwei zweite Magnetfeldsensoren zur zweiten Teilanordnung (126) zugeordnet.

In einer Ausführungsform beträgt die erste Komponente zwischen 0,35 und 0,65 des ersten Abstands und die zweite Komponente zwischen 0,35 und 0,65 des zweiten Abstands.

In einer Ausführungsform entspricht die erste Komponente dem halben ersten Abstand und die zweite Komponente dem halben zweiten Abstand.

In einer Ausführungsform stehen die erste Richtung und die zweite Richtung senkrecht zueinander. In einer Ausführungsform ist das Sensormodul rechteckig, insbesondere quadratisch. In einer Ausführungsform sind der erste Abstand und der zweite Abstand gleich groß. In einer Ausführungsform des Sensormoduls sind die Magnetfeldsensoren Hall-Sensoren, insbesondere 3D-Hall-Sensoren. In einer Ausführungsform des Sensormoduls weist der Träger eine Leiterplatte, insbesondere eine Platine, auf. In einer Ausführungsform des Sensormoduls umfasst die Anordnung von Magnetfeldsensoren genau zwei Teilanordnungen von Magnetfeldsensoren.

In einer Ausführungsform weist der Träger eine Durchgangsöffnung auf, wobei vier Magnetfeldsensoren an die Durchgangsöffnung angrenzen, wobei zwei der vier Magnetfeldsensoren der ersten Teilanordnung und zwei der vier Magnetfeldsensoren der zweiten Teilanordnung zugeordnet sind. In einer Ausführungsform weist der Träger mehrere Durchgangsöffnungen auf, wobei jeweils vier Magnetfeldsensoren an die Durchgangsöffnungen angrenzen, wobei zwei der vier Magnetfeldsensoren, welche an eine der Durchgangsöffnungen angrenzen, der ersten Teilanordnung und zwei der vier Magnetfeldsensoren, welche an diese Durchgangsöffnung angrenzen, der zweiten Teilanordnung zugeordnet sind.

In einer Ausführungsform sind die Durchgangsöffnungen viereckig und/oder fünfeckig ausgeführt. In einer Ausführungsform sind die Durchgangsöffnungen in einem äußeren Bereich des Trägers angeordnet, wobei der äußere Bereich ringförmig um einen inneren Bereich des Trägers angeordnet ist und wobei der äußere Bereich des Trägers mindestens 50 Prozent, insbesondere mindestens 75 Prozent, insbesondere mindestens 85 Prozent einer Fläche des Trägers umfasst.

Die Erfindung wird nachfolgend anhand von Ausführungsbeispielen und unter Bezugnahme auf Figuren näher erläutert. Dabei zeigen jeweils in schematischer Darstellung
- Fig. 1: ein erstes Ausführungsbeispiel eines Sensormoduls;
- Fig. 2: ein zweites Ausführungsbeispiel eines Sensormoduls;
- Fig. 3: ein drittes Ausführungsbeispiel eines Sensormoduls;
- Fig. 4: ein viertes Ausführungsbeispiel eines Sensormoduls;
- Fig. 5: ein fünftes Ausführungsbeispiel eines Sensormoduls;
- Fig. 6: eine isometrische Ansicht eines Statormoduls mit einem Läufer;
- Fig. 7: einen isometrischen Teilschnitt durch ein Statormodul;
- Fig. 8: eine Schnittdarstellung durch ein Statormodul;
- Fig. 9: eine weitere Schnittdarstellung durch ein Statormodul;
- Fig. 10: eine isometrische Ansicht mehrerer Statormodule mit einem Läufer;
- Fig. 11: einen Läufer eines Planarantriebssystems;
- Fig. 12: eine Magneteinheit eines Läufers;
- Fig. 13: eine relative Anordnung von Magneteinheiten eines Läufers relativ zu Magnetfeldsensoren einer Positionserfassungseinheit in einem Planarantriebssystem; und
- Fig. 14: ein weiteres Ausführungsbeispiel eines Läufers.

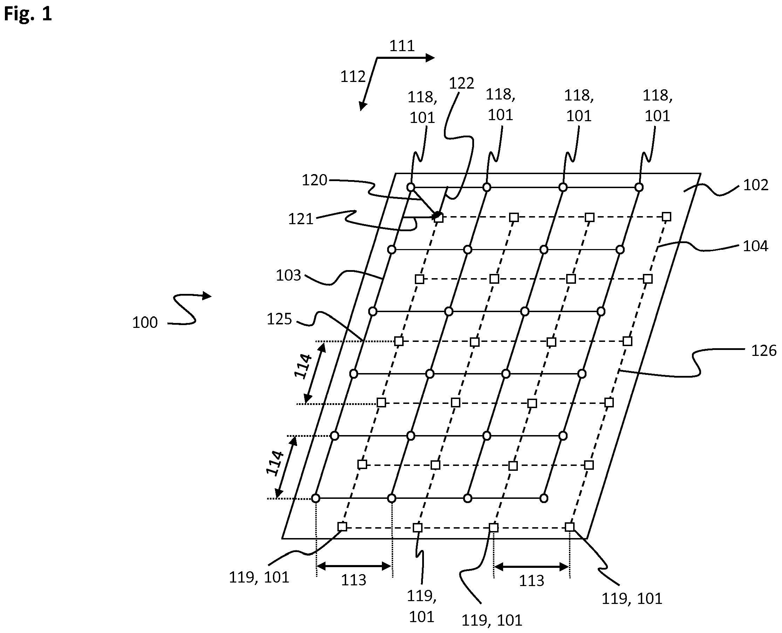

Die Erfindung betrifft im Wesentlichen Weiterentwicklungen der in den Veröffentlichungen WO 2013/059934 A1, WO 2015/017933 A1, WO 2015/179962 A1, WO 2015/184553 A1, WO 2015/188281 A1 und WO 2017/004716 A1 offenbarten Planarantriebssysteme. Fig. 1 zeigt eine Draufsicht auf ein Sensormodul 100 zur Erfassung einer Position eines Läufers in einem Planarantriebssystem. Das Sensormodul 100 ist parallelogrammförmig und weist eine zweidimensionale Anordnung von Magnetfeldsensoren 101 auf einem Träger 102 auf. Die Magnetfeldsensoren 101 sind also auf dem Träger 102 angeordnet. Die zweidimensionale Anordnung der Magnetfeldsensoren 101 weist eine erste Teilanordnung 125 von Magnetfeldsensoren 101 und eine zweite Teilanordnung 126 von Magnetfeldsensoren 101 auf. Die erste Teilanordnung 125 von Magnetfeldsensoren 101 ist dabei in einem ersten periodischen Gitter 103 angeordnet, die zweite Teilanordnung 126 von Magnetfeldsensoren 101 ist in einem zweiten periodischen Gitter 104 angeordnet. Die Magnetfeldsensoren 101 der ersten Teilanordnung 125 im ersten Gitter 103 sind dabei durch runde Symbole angedeutet, während die Magnetfeldsensoren 101 der zweiten Teilanordnung 126 des zweiten Gitters 104 durch viereckige Symbole angedeutet sind.
Sofern im Folgenden auf die Magnetfeldsensoren 101 allgemein eingegangen wird, findet das Bezugszeichen 101 Verwendung. Sofern die Magnetfeldsensoren 101 in Zusammenhang mit der ersten Teilanordnung 125 bzw. dem ersten Gitter 103 und/oder der zweiten Teilanordnung 126 bzw. dem zweiten Gitter 104 beschrieben werden, wird im Folgenden das Bezugszeichen 118 für erste Magnetfeldsensoren 118 der ersten Teilanordnung 125 bzw. des ersten Gitters 103 und das Bezugszeichen 119 für zweite Magnetfeldsensoren 119 der zweiten Teilanordnung 126 bzw. des zweiten Gitters 104 verwendet.
Die ersten Magnetfeldsensoren 118 sind mit durchgezogenen Linien zur Verdeutlichung der Gitterstruktur des ersten Gitters 103 verbunden. Die zweiten Magnetfeldsensoren 119 sind mit gestrichelten Linien zur Verdeutlichung der Gitterstruktur des zweiten Gitters 104 verbunden. Die ersten Magnetfeldsensoren 118 und die zweiten Magnetfeldsensoren 119 können dabei identisch sein, die runden beziehungsweise eckigen Symbole sollen nur die Positionen der Magnetfeldsensoren 101 zugehörig zu den jeweiligen Teilanordnungen 125, 126 symbolisieren. Die ersten Magnetfeldsensoren 118 weisen in einer ersten Richtung 111 einen ersten Abstand 113 zueinander auf. Die ersten Magnetfeldsensoren 118 weisen in einer zweiten Richtung 112 einen zweiten Abstand 114 zueinander auf. Die zweiten Magnetfeldsensoren 119 sind in der ersten Richtung 111 ebenfalls in einem ersten Abstand 113 zueinander und in der zweiten Richtung 112 ebenfalls in einem zweiten Abstand 114 zueinander angeordnet. Das erste Gitter 103 und das zweite Gitter 104 sind identisch aufgebaut und zueinander um einen Vektor 120 verschoben, wobei der Vektor 120 eine erste Komponente 121 in der ersten Richtung 111 und eine zweite Komponente 122 in der zweiten Richtung 112 aufweist. Der Betrag der ersten Komponente 121 ist dabei kleiner als der erste Abstand 113 und der Betrag der zweiten Komponente 122 ist dabei kleiner als der zweite Abstand 114. Dadurch sind die zweiten Magnetfeldsensoren 119 des zweiten Gitters 104 und die ersten Magnetfeldsensoren 118 des ersten Gitters 103 jeweils zueinander verschoben, wobei zumindest in einem Teilbereich des Sensormoduls 100 jeweils zwischen vier ersten Magnetfeldsensoren 118 ein zweiter Magnetfeldsensor 119 angeordnet ist. Das erste Gitter 103 stellt dabei eine erste Teilanordnung 125 einer Anordnung von Magnetfeldsensoren 101 dar, während das zweite Gitter 104 eine zweite Teilanordnung 126 von Magnetfeldsensoren 101 darstellt. Beide Teilanordnungen 125, 126 umfassen jeweils eine identische Anzahl von ersten und zweiten Magnetfeldsensoren 118, 119.

Die erste Komponente 121 kann zwischen 0,35 und 0,65 des ersten Abstands 113 betragen. Die zweite Komponente 122 kann zwischen 0,35 und 0,65 des zweiten Abstands 114 betragen.

Die erste Komponente 121 kann der Hälfte des ersten Abstands 113 und die zweite Komponente 122 der Hälfte des zweiten Abstands 114 entsprechen.

Ein Winkel zwischen der ersten Richtung 111 und der zweiten Richtung 112 kann dabei zwischen 0 und 180 Grad betragen. Insbesondere kann der Winkel zwischen der ersten Richtung 111 und der zweiten Richtung 112 zwischen 60 Grad und 120 Grad betragen.

In der ersten Richtung 111 weist das erste Gitter 103 jeweils vier nebeneinander, mit erstem Abstand 113 angeordnete, erste Magnetfeldsensoren 118 auf, ebenso weist das zweite Gitter 104 jeweils vier nebeneinander, mit erstem Abstand 113 angeordnete, zweite Magnetfeldsensoren 119 auf. In die zweite Richtung 112 weist das erste Gitter 103 jeweils sechs nebeneinander, mit zweitem Abstand 114 angeordnete, erste Magnetfeldsensoren 118 auf, ebenso weist das zweite Gitter 104 jeweils sechs nebeneinander, mit zweitem Abstand 114 angeordnete, zweite Magnetfeldsensoren 119 auf. Es können jedoch auch andere Anzahlen von Magnetfeldsensoren 101 in den beiden Richtungen 111, 112 vorgesehen sein.

Der Träger 102 ist eben, so dass die Magnetfeldsensoren 101 in einer Ebene, also in einer zweidimensionalen Anordnung, angeordnet sind.

Die Magnetfeldsensoren 101 können als Hall-Sensoren ausgebildet sein. Insbesondere können die Magnetfeldsensoren 101 als 2D- oder 3D-Hall-Sensoren ausgebildet sein, wobei 3D-Hall-Sensoren die Magnetfeldkomponenten in drei linear unabhängigen Raumrichtungen messen. Diese Raumrichtungen können insbesondere die erste Richtung 111 und die zweite Richtung 112 sowie eine dritte Richtung senkrecht zur ersten Richtung 111 und zur zweiten Richtung 112 umfassen.

Der Träger 102 kann als eine Leiterplatte und/oder eine Platine ausgebildet sein. Dadurch kann der Träger 102 auf einfachem Weg bereitgestellt werden.

Die Anordnung von Magnetfeldsensoren 101 kann genau zwei Teilanordnungen 125, 126 der zwei Gitter 103, 104 umfassen.

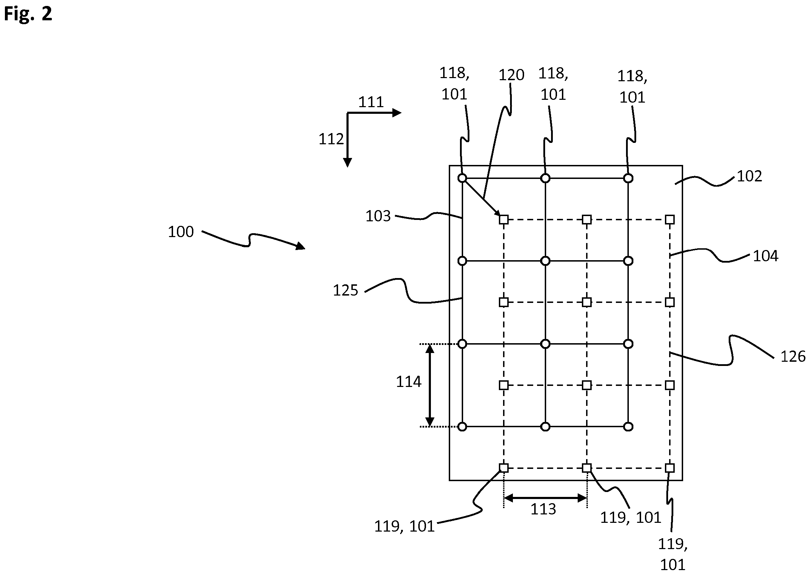

Fig. 2 zeigt eine Draufsicht auf ein weiteres Sensormodul 100, das, soweit im Folgenden keine Unterschiede beschrieben sind, dem Sensormodul der Fig. 1 entspricht. Die erste Richtung 111 und die zweite Richtung 112 stehen senkrecht aufeinander. Ferner ist das Sensormodul 100 rechteckig. In der ersten Richtung 111 sind jeweils drei nebeneinander, mit erstem Abstand 113 positionierte, erste Magnetfeldsensoren 118 und jeweils drei nebeneinander, mit erstem Abstand 113 positionierte, zweite Magnetfeldsensoren 119 angeordnet. In der zweiten Richtung 112 sind jeweils vier nebeneinander, mit zweitem Abstand 114 positionierte, erste Magnetfeldsensoren 118 beziehungsweise jeweils vier nebeneinander, mit zweitem Abstand 114 positionierte, zweite Magnetfeldsensoren 119 angeordnet. Die ersten Magnetfeldsensoren 118 sind dabei wieder durch runde Symbole, die zweiten Magnetfeldsensoren 119 sind wiederum jeweils durch eckige Symbole angedeutet. Der erste Abstand 113 zwischen zwei benachbarten Magnetfeldsensoren 101 in der ersten Richtung 111 und der zweite Abstand 114 zwischen zwei Magnetfeldsensoren 101 in der zweiten Richtung 112 sind dabei identisch. Bei einem hier nicht dargestellten Ausführungsbeispiel ist es auch möglich, dass das Sensormodul 100 quadratisch ist und jeweils drei erste Magnetfeldsensoren 118 sowie jeweils drei zweite Magnetfeldsensoren 119 in der ersten Richtung 111 sowie in der zweiten Richtung 112 aufweist.

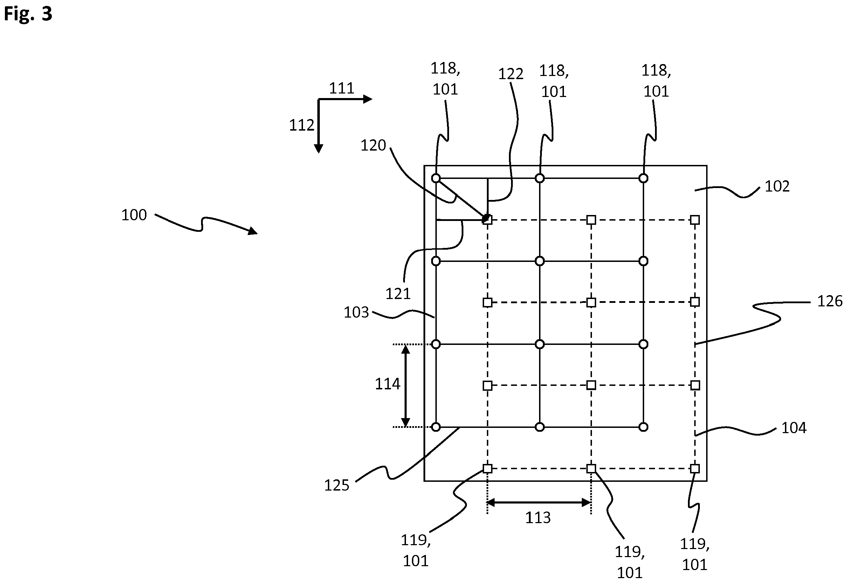

Fig. 3 zeigt eine Draufsicht auf ein weiteres Ausführungsbeispiel eines Sensormoduls 100, das, soweit im Folgenden keine Unterschiede beschrieben sind, dem Sensormodul der Fig. 2 entspricht. Der erste Abstand 113 in der ersten Richtung 111 ist größer als der zweite Abstand 114 in der zweiten Richtung 112. Das Sensormodul 100 ist quadratisch. In der ersten Richtung 111 sind jeweils drei nebeneinander, mit erstem Abstand 113 positionierte, erste Magnetfeldsensoren 118 sowie jeweils drei nebeneinander, mit erstem Abstand 113 positionierte, zweite Magnetfeldsensoren 119 angeordnet. In der zweiten Richtung 112 sind jeweils vier nebeneinander, mit zweitem Abstand 114 positionierte, erste Magnetfeldsensoren 118 sowie jeweils vier nebeneinander, mit zweitem Abstand 114 positionierte, zweite Magnetfeldsensoren 119 angeordnet. Eine Anordnung von Magnetfeldsensoren 101 innerhalb des Sensormoduls 100, wie sie in Fig. 3 gezeigt ist, kann dann genutzt werden, wenn die Positionsbestimmung eines Läufers in der zweiten Richtung 112 genauer sein soll als die Positionsbestimmung des Läufers in der ersten Richtung 111.

Zusätzlich kann, wie in Fig. 3 dargestellt, bei allen Ausführungsbeispielen der Anordnung von Magnetfeldsensoren 101 der Vektor 120 so ausgebildet sein, dass die erste Komponente 121 dem halben ersten Abstand 113 entspricht, während die zweite Komponente 122 dem halben zweiten Abstand 114 entspricht. Dann sind zumindest in einem Teilbereich des Sensormoduls 100 die zweiten Magnetfeldsensoren 119 jeweils mittig zwischen vier ersten Magnetfeldsensoren 118 platziert.

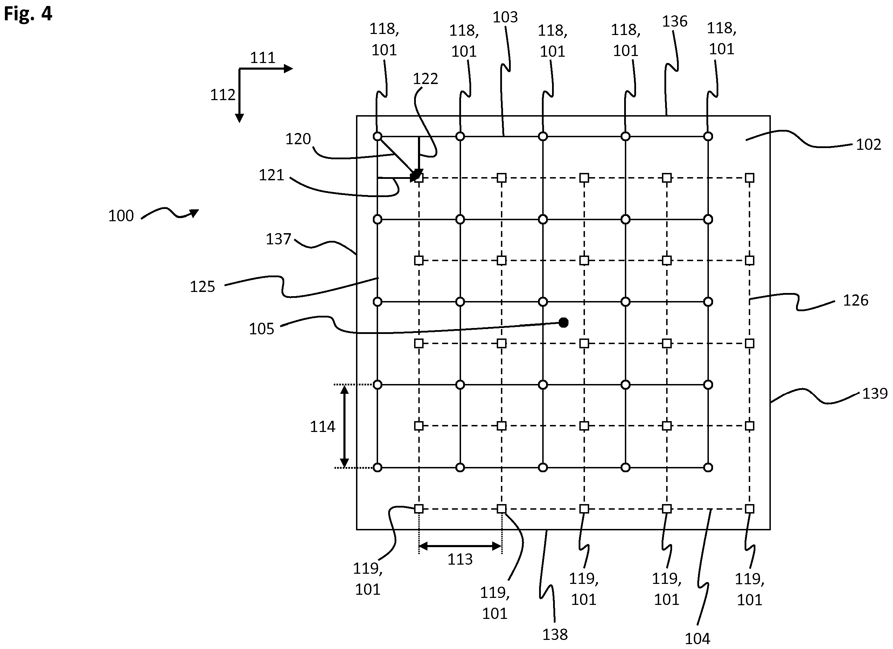

Fig. 4 zeigt eine Draufsicht auf ein weiteres Ausführungsbeispiel eines Sensormodul 100, das, soweit im Folgenden keine Unterschiede beschrieben sind, dem Sensormodul der Fig. 2 entspricht. Der Träger 102 des Sensormoduls ist quadratisch. In der ersten Richtung 111 sind jeweils fünf nebeneinander, mit erstem Abstand 113 positionierte, erste Magnetfeldsensoren 118 sowie jeweils fünf nebeneinander, mit erstem Abstand 113 positionierte, zweite Magnetfeldsensoren 119 angeordnet. In der zweiten Richtung 112 sind ebenfalls jeweils fünf nebeneinander, mit zweitem Abstand 114 positionierte, erste Magnetfeldsensoren 118 sowie jeweils fünf nebeneinander, mit zweitem Abstand 114 positionierte, zweite Magnetfeldsensoren 119 angeordnet. Der Vektor 120 ist so ausgebildet, dass die erste Komponente 121 dem halben ersten Abstand 113 entspricht, während die zweite Komponente 122 dem halben zweiten Abstand 114 entspricht. Dadurch sind zumindest in einem mittigen Bereich des Sensormoduls 100 die zweiten Magnetfeldsensoren 119 mittig zwischen den ersten Magnetfeldsensoren 118 angeordnet sowie die ersten Magnetfeldsensoren 118 mittig zwischen den zweiten Magnetfeldsensoren 119 angeordnet.

Insgesamt weist das Sensormodul 100 eine Anordnung von Magnetfeldsensoren 101, bestehend aus fünfundzwanzig ersten Magnetfeldsensoren 118 einer ersten Teilanordnung 125 der Magnetfeldsensoren 101 und fünfundzwanzig zweite Magnetfeldsensoren 119 einer zweiten Teilanordnung 126 der Magnetfeldsensoren 101 auf.

Der Träger 102 weist eine erste Seite 136 auf, die parallel zur ersten Richtung 111 angeordnet ist. Eine zweite Seite 137 des Trägers 102 ist parallel zur zweiten Richtung 112 angeordnet. Eine dritte Seite 138 des Trägers 102 liegt der ersten Seite 136 gegenüber. Eine vierte Seite 139 des Trägers 102 liegt der zweiten Seite gegenüber.

Die Anordnung der Magnetfeldsensoren 101 weist einen Mittelpunkt 105 auf und sie ist punktsymmetrisch bezüglich des Mittelpunkts 105. Dies bedeutet, dass wenn die Anordnung der Magnetfeldsensoren 101 um die Hochachse in dem Mittelpunkt 105 um 180° gedreht wird, sich die Anordnung der Magnetfeldsensoren 101 nicht ändert. Erste Magnetfeldsensoren 118 nehmen nach der Drehung um 180° die Positionen von zweiten Magnetfeldsensoren 119 vor der Drehung an und umgekehrt.

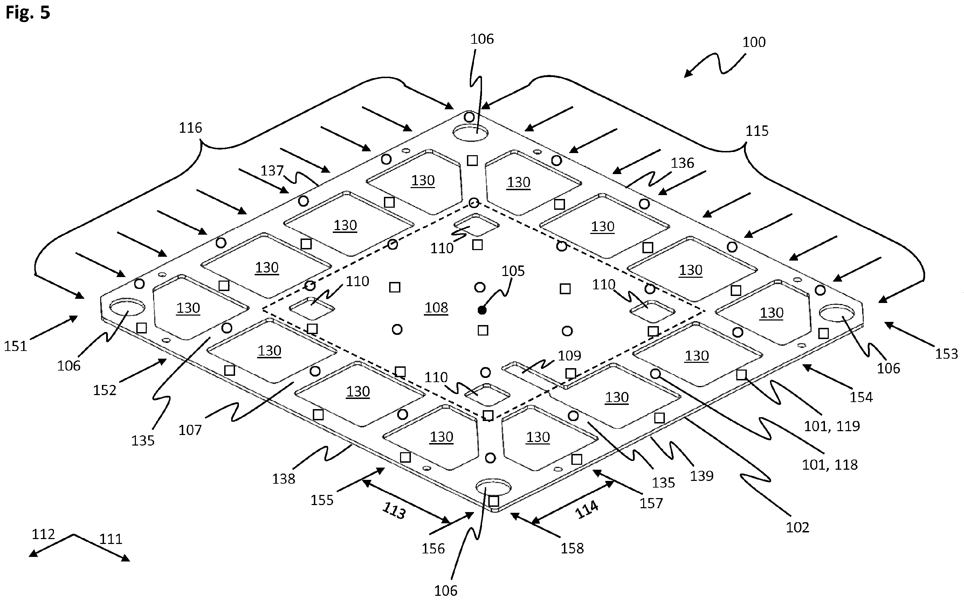

Fig. 5 zeigt ein weiteres Ausführungsbeispiel eines Sensormoduls 100, das, sofern im Folgenden keine Unterschiede beschrieben sind, dem Sensormodul der Fig. 4 entspricht. Der Träger 102 ist in einen äußeren Bereich 107 und einen inneren Bereich 108 aufgeteilt. Der innere Bereich 108 ist quadratisch ausgebildet und mittig im Zentrum des Trägers 102 angeordnet. Der äußere Bereich 107 ist ringförmig um den inneren Bereich 108 herum angeordnet. Der äußere Bereich 107 kann auch als Randbereich bezeichnet werden. Im äußeren Bereich 107 weist der Träger 102 Durchgangsöffnungen 130 sowie Ausrichtungslöcher 106 auf. Mit den Ausrichtungslöchern 106 kann der Träger 102 und damit das Sensormodul 100 innerhalb eines Statormoduls ausgerichtet werden. Die Durchgangsöffnungen 130 sind jeweils zwischen vier Magnetfeldsensoren 101 und dabei jeweils zwischen zwei ersten Magnetfeldsensoren 118 und zwei zweiten Magnetfeldsensoren angeordnet. Die ersten Magnetfeldsensoren 118 sind wieder durch runde Symbole, die zweiten Magnetfeldsensoren 119 sind wieder durch eckige Symbole dargestellt.

Die Durchgangsöffnungen 130 sind teilweise viereckig und teilweise fünfeckig ausgeführt. Parallel zu einer ersten Seite 136 des Trägers 102 sind im äußeren Bereich 107 entlang der ersten Richtung 111 von der zweiten Seite 137 her gesehen in Richtung der vierten Seite 139 des Trägers 102 ein Ausrichtloch 106, daran angrenzend eine fünfeckige Durchgangsöffnung 130, daran angrenzend zwei viereckige Durchgangsöffnungen 130, erneut eine fünfeckige Durchgangsöffnung 130 und erneut ein Ausrichtloch 106 ausgebildet. Dabei ist, wie dargestellt, das an der vierten Seite 139 angrenzende Ausrichtloch 106 neben einer abgeflachten Ecke der fünfeckigen Durchgangsöffnung 130 angeordnet. Die in Bezug auf die erste Seite 136 beschriebene Anordnung wiederholt sich an der dritten Seite 138 des Trägers 102 im äußeren Bereich 107 entlang der ersten Richtung 111 von der vierten Seite 139 her gesehen in Richtung der zweiten Seite 137 des Trägers 102. Parallel zu einer zweiten Seite 137 des Trägers 102 sind im äußeren Bereich 107 entlang der zweiten Richtung 112 von der ersten Seite 136 her gesehen in Richtung der dritten Seite 138 des Trägers 102 ein Ausrichtloch 106, daran angrenzend eine fünfeckige Durchgangsöffnung 130, daran angrenzend zwei viereckige Durchgangsöffnungen 130, erneut eine fünfeckige Durchgangsöffnung 130 und erneut ein Ausrichtloch 106 ausgebildet. Dabei ist, wie dargestellt, das an der dritten Seite 138 angrenzende Ausrichtloch 106 neben einer abgeflachten Ecke der fünfeckigen Durchgangsöffnung 130 angeordnet. Die in Bezug auf die zweite Seite 137 beschriebene Anordnung wiederholt sich an der vierten Seite 139 des Trägers 102 im äußeren Bereich 107 entlang der zweiten Richtung 112 von der dritten Seite 138 her gesehen in Richtung der ersten Seite 136 des Trägers 102. Zwischen den Durchgangsöffnungen 130 ist jeweils ein Steg 135 mit einem ersten Magnetfeldsensor 118 oder einem zweiten Magnetfeldsensor 119 angeordnet. Insgesamt weist der Träger 102 also acht viereckige Durchgangsöffnungen 130 und sechs fünfeckige Durchgangsöffnungen 130 auf. Anstelle der vierzehn Durchgangsöffnungen 130 kann auch eine geringere Anzahl von Durchgangsöffnungen 130, insbesondere nur eine Durchgangsöffnung 130 vorgesehen sein. Bei einer alternativen Ausführungsform können auch mehr und/oder anders geformte Durchgangsöffnungen 130 vorgesehen sein. Innerhalb eines Statormoduls, also wenn der Träger 102 in einem Statormodul verbaut ist, können die Durchgangsöffnungen 130 zur Durchführung von Wärmeleitelementen dienen. Eine Durchgangsöffnung 130 weist eine schlitzförmige Erweiterung 109 auf, welche diese Durchgangsöffnung 130 bis in den inneren Bereich 108 erweitert. Diese schlitzförmige Erweiterung 109 kann zum Durchführen einer elektrischen Kontaktierung dienen. Zusätzlich sind in inneren Bereich 108 weitere Durchgangsöffnungen 110 vorgesehen, die zur Durchführung von elektrischen Kontaktierungen dienen können.

Die Durchgangsöffnungen 130 an der ersten Seite 136 des Trägers 102 liegen jeweils einem Steg 135 an der dritten Seite 138 des Trägers 102 gegenüber. Die Stege 135 an der dritten Seite 138 liegen den Durchgangsöffnungen 130 an der ersten Seite 136 mittig gegenüber. Die Durchgangsöffnungen 130 an der dritten Seite 138 des Trägers 102 liegen jeweils einem Steg 135 an der ersten Seite 136 des Trägers 102 gegenüber. Die Stege 135 an der ersten Seite 136 liegen den Durchgangsöffnungen 130 an der dritten Seite 138 mittig gegenüber. Dabei ist auf den Stegen 135 an der ersten Seite 136 ein zweiter Magnetfeldsensor 119 angeordnet, während auf den Stegen 135 angrenzend an die dritte Seite 138 jeweils ein erster Magnetfeldsensor 118 angeordnet ist. Die Durchgangsöffnungen 130 an der zweiten Seite 137 des Trägers 102 liegen jeweils einem Steg 135 an der vierten Seite 139 des Trägers 102 gegenüber. Die Stege 135 an der vierten Seite 139 liegen den Durchgangsöffnungen 130 an der zweiten Seite 137 mittig gegenüber. Die Durchgangsöffnungen 130 an der vierten Seite 139 des Trägers 102 liegen jeweils einem Steg 135 an der zweiten Seite 137 des Trägers 102 gegenüber. Dabei ist auf den Stegen 135 an der zweiten Seite 137 ein zweiter Magnetfeldsensor 119 angeordnet, während auf den Stegen 135 angrenzend an die vierte Seite 139 ein erster Magnetfeldsensor 118 angeordnet ist.

Eine Fläche des äußeren Bereichs 107 beträgt dabei mehr als 50 Prozent einer Fläche des gesamten Trägers 102, insbesondere mehr als 75 Prozent, insbesondere mehr als 85 Prozent.

Die Magnetfeldsensoren 101 sind im ersten Gitter 103 sowie im zweiten Gitter 104 jeweils in fünf Spalten 115 und fünf Reihen 116 angeordnet. Dadurch umfasst das Positionserfassungsmodul 100 insgesamt zehn Spalten 115 sowie zehn Reihen 116 von Magnetfeldsensoren 101. Die Spalten 115 sind dabei parallel zur zweiten Richtung 112, die Reihen 116 sind parallel zur ersten Richtung 111 ausgerichtet. An der ersten Seite 136 des Trägers 102 sind die Durchgangsöffnungen 130 zwischen einer ersten Reihe 153 des in Figur 4 dargestellten ersten Gitters 103 mit ersten Magnetfeldsensoren 118 und einer zweiten Reihe 154 des ersten Gitters 103 mit ersten Magnetfeldsensoren 118 angeordnet. Der Übersichtlichkeit halber sind das erste Gitter 103 und das zweite Gitter 104 in Figur 5 nicht dargestellt. Diesbezüglich wird dann stets auf die Beschreibung im Zusammenhang mit Figur 4 verwiesen. Die Durchgangsöffnungen 130 sind an der zweiten Seite 137 des Trägers 102 zwischen einer ersten Spalte 151 des ersten Gitters 103 mit ersten Magnetfeldsensoren 118 und einer zweiten Spalte 152 des ersten Gitters 103 mit ersten Magnetfeldsensoren 118 angeordnet. An der dritten Seite 138 des Trägers 102 sind die Durchgangsöffnungen 130 zwischen einer vierten Reihe 157 des zweiten Gitters 104 mit zweiten Magnetfeldsensoren 119 und einer fünften Reihe 158 des zweiten Gitters 104 mit zweiten Magnetfeldsensoren 119 angeordnet. An der vierten Seite 139 des Trägers 102 sind die Durchgangsöffnungen 130 zwischen einer vierten Spalte 155 des zweiten Gitters 104 mit zweiten Magnetfeldsensoren 119 und einer fünften Spalte 156 des zweiten Gitters 104 mit zweiten Magnetfeldsensoren 119 angeordnet. Dadurch sind die Durchgangsöffnungen 130 im Wesentlichen in dem ringförmigen äußeren Bereich 107 umlaufend um den inneren Bereich 108 angeordnet. Es kann vorgesehen sein, dass die Durchgangsöffnungen 130 ausschließlich im ringförmigen äußeren Bereich 107 umlaufend um den inneren Bereich 108 angeordnet sind.

Wenn das erste Gitter 103 mit ersten Magnetfeldsensoren 118 und das zweite Gitter 104 mit zweiten Magnetfeldsensoren 119 eine von fünf verschiedene Anzahl von Magnetfeldsensoren 101 in der ersten Richtung 111 und/oder der zweiten Richtung 112 aufweisen, kann es vorgesehen sein, dass an der dritten Seite 138 des Trägers 102 die Durchgangsöffnungen 130 zwischen einer vorletzten Reihe des zweiten Gitters 104 mit zweiten Magnetfeldsensoren 119 und einer letzten Reihe des zweiten Gitters 104 mit zweiten Magnetfeldsensoren 119 angeordnet sind, während an der vierten Seite 139 des Trägers 102 die Durchgangsöffnungen 130 zwischen einer vorletzten Spalte des zweiten Gitters 104 mit zweiten Magnetfeldsensoren 119 und einer letzten Spalte des zweiten Gitters 104 mit zweiten Magnetfeldsensoren 119 angeordnet sind.

Die Stege 135 können alternativ den Durchgangsöffnungen 130 nicht-mittig gegenüberliegen.

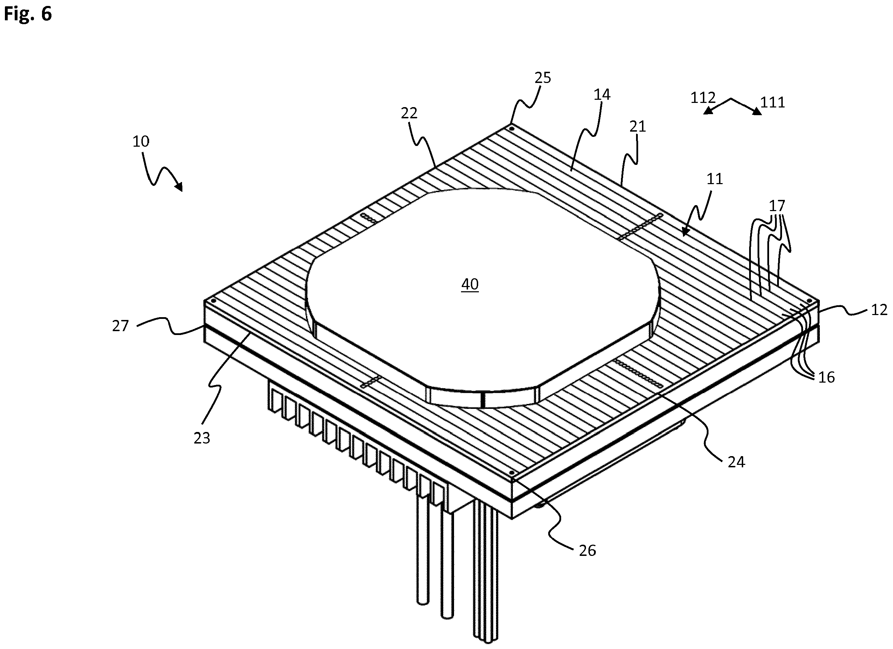

Fig. 6 zeigt eine isometrische Ansicht eines Statormoduls 10 mit einer ebenen Statoroberfläche 11. Die ebene Statoroberfläche 11 ist an einer Oberseite eines Statormodulgehäuses 12 angeordnet. Oberhalb der Statoroberfläche 11 ist ein Läufer 40 angeordnet. Die Statoroberfläche 11 ist Teil einer Statoreinheit 14 für einen elektrischen Antrieb des Läufers 40. Die Statoreinheit 14 mit der Statoroberfläche 11 kann als Leiterplatte ausgeführt sein. Die Statoroberfläche 11 ist quadratisch mit einer ersten Seite 21, einer zweiten Seite 22, einer dritten Seite 23 und einer vierten Seite 24, wobei die erste Seite 21 der dritten Seite 23 gegenüberliegt und die zweite Seite 22 der vierten Seite 24 gegenüberliegt. Die Statoroberfläche 11 weist einen ersten Eckbereich 25 zwischen der ersten Seite 21 und der zweiten Seite 22 auf. Ferner weist die Statoroberfläche 11 einen zweiten Eckbereich 26 auf, der dem ersten Eckbereich 25 gegenüberliegt, also zwischen der dritten Seite 23 und der vierten Seite 24 angeordnet ist. Die Seiten 21, 22, 23, 24 bilden Kanten der Statoroberfläche 11 und begrenzen die Statoroberfläche 11.

Der Läufer 40 ist oberhalb der Statoroberfläche 11 zumindest in die erste Richtung 111 und in die zweite Richtung 112 antreibbar. Die Statoroberfläche 11 weist mehrere Leiterstreifen 16 auf, die im Wesentlichen entlang der ersten Richtung 111 ausgerichtet sind. Die Leiterstreifen 16 sind stromleitend ausgebildet und können so bestromt werden, dass der Läufer 40 angetrieben wird. Zwischen den Leiterstreifen 16 ist ein Leiterstreifenzwischenraum 17 vorgesehen, durch den die Leiterstreifen 16 voneinander elektrisch isoliert sind. Zwei benachbarte Leiterstreifen 16 können in der zweiten Richtung 112 einen ersten Leiterstreifenabstand von fünf Sechsunddreißigstel des zweiten Abstands aufweisen, wobei der erste Leiterstreifenabstand als Entfernung zwischen zwei Mittellinien der entlang der ersten Richtung ausgerichteten Leiterstreifen definiert ist. Unterhalb der Statoroberfläche 11 kann eine weitere Anordnung von Leiterstreifen vorgesehen sein, in der die Leiterstreifen im Wesentlichen entlang der zweiten Richtung 112 ausgerichtet sind. Die Mittellinien dieser Leiterstreifen können in einem Abstand von fünf Sechsunddreißigstel des ersten Abstands angeordnet sein.

Das Statormodulgehäuse 12 weist eine Schnittebene 27 auf. Auf Höhe der Schnittebene 27 kann innerhalb des Statormodulgehäuses 12 ein Sensormodul angeordnet sein.

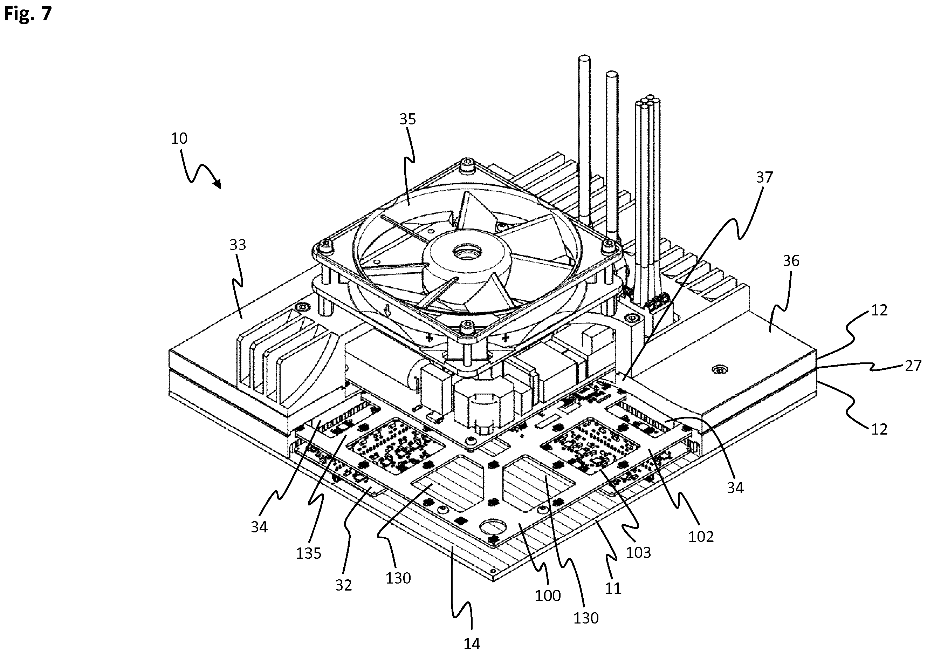

Fig. 7 zeigt eine weitere isometrische, im Verhältnis zu Figur 6 um 180° um eine entlang der ersten Richtung 111 ausgebildeten Achse gedrehte Ansicht des quadratischen Statormoduls 10 der Fig. 6, bei dem das Gehäuse 12 teilweise aufgeschnitten ist, sodass ein Innenleben des Statormoduls 10 sichtbar wird. Die Statoroberfläche 11 ist demnach in Fig. 7 unten angeordnet. Die weiteren Elemente des Statormoduls 10 sind oberhalb der Statoroberfläche 11 angeordnet. Direkt oberhalb der Statoreinheit 14 ist ein Leistungsmodul 32 angeordnet, welches die Statoreinheit 14 mit der Statoroberfläche 11 mit elektrischer Leistung versorgt. Über dem Leistungsmodul 32, auf Höhe der Schnittebene 27, ist ein Sensormodul 100 angeordnet, welches dem Sensormodul 100 der Figur 5 entspricht. Auf diesem Sensormodul 100, welches einen Träger 102 aufweist, sind hier nicht sichtbare Magnetfeldsensoren in Richtung der Statoroberfläche 11 gemäß der Beschreibung zu den Figuren 4 und 5 angeordnet. Ferner weist das Sensormodul 100 Durchgangsöffnungen 130 auf, wobei Wärmeleitelemente 34 durch die Durchgangsöffnungen 130 zu einer Unterseite 33 des Gehäuses 12 geführt sind. Die Wärmeleitelemente 34 sind dazu ausgebildet, beim Betrieb des Leistungsmoduls 32 und der Statoreinheit 14 entstehende Abwärme zur Unterseite 33 des

Statormodulgehäuses 12 zu leiten. Dazu stehen die Wärmeleitelemente 34 mit der Statoreinheit 14 in thermischem Kontakt, beispielsweise, indem die Wärmeleitelemente 34 an der Statoreinheit 14 anliegen oder über eine zwischen den Wärmeleitelementen 34 und der Statoreinheit 14 angeordnete Wärmeleitpaste thermisch kontaktiert sind. Zusätzlich stehen die Wärmeleitelemente 34 mit der Unterseite 33 des Statorgehäuses 12 in thermischem Kontakt, der ebenfalls beispielsweise durch ein direktes Anliegen der Wärmeleitelemente 34 an die Unterseite 33 oder durch eine zwischen den Wärmeleitelementen 34 und der Unterseite 33 angeordnete Wärmeleitpaste hergestellt werden kann. Die Wärmeleitelemente 34 bilden also eine wärmeleitende Verbindung zwischen der Statoreinheit 14 und der Unterseite 33 des Statorgehäuses 12. Auf der Unterseite 33 ist ein Lüfter 35 angeordnet, der zur weiteren Kühlung dienen kann. Zusätzlich kann vorgesehen sein, dass durch Durchgangsöffnungen 130 elektrische Kontaktierungen für das Leistungsmodul 32 geführt sind.

Die Wärmeleitelemente 34 können materialeinheitlich und/oder einstückig mit dem Statormodulgehäuse 12 ausgeführt sein. Die Wärmeleitelemente 34 können Aluminium aufweisen oder aus Aluminium bestehen. Das Statormodulgehäuse 12 kann Aluminium aufweisen oder aus Aluminium bestehen.

Dadurch, dass die Wärmeleitelemente 34 durch die Durchgangsöffnungen 130 geführt sind, sind die Wärmeleitstrukturen 34 in einem Randbereich 36 des Gehäuses 12 angeordnet, wobei ein mittlerer Bereich 37 des Gehäuses frei von den Wärmeleitstrukturen ist. Die Stege 135 des Trägers 102 des Sensormoduls 100 sind jeweils zwischen den Wärmeleitelementen 34 angeordnet.

Anstelle des Sensormoduls der Fig. 5 kann auch eines der Sensormodule der Fig. 1 bis 4 innerhalb des Statormodulgehäuses 12 vorgesehen sein. Die Statoroberfläche 11 kann dann analog zum Sensormodul quadratisch, rechteckig oder parallelogrammförmig sein.

Die erste Seite der Statoroberfläche 11 kann eine Länge aufweisen, die einem ganzzahligen Vielfachen, hier dem Fünffachen, des ersten Abstands 113 beträgt. Die zweite Seite der Statoroberfläche 11 kann eine Länge aufweisen, die einem ganzzahligen Vielfachen, hier dem Fünffachen, des zweiten Abstands 115 beträgt.

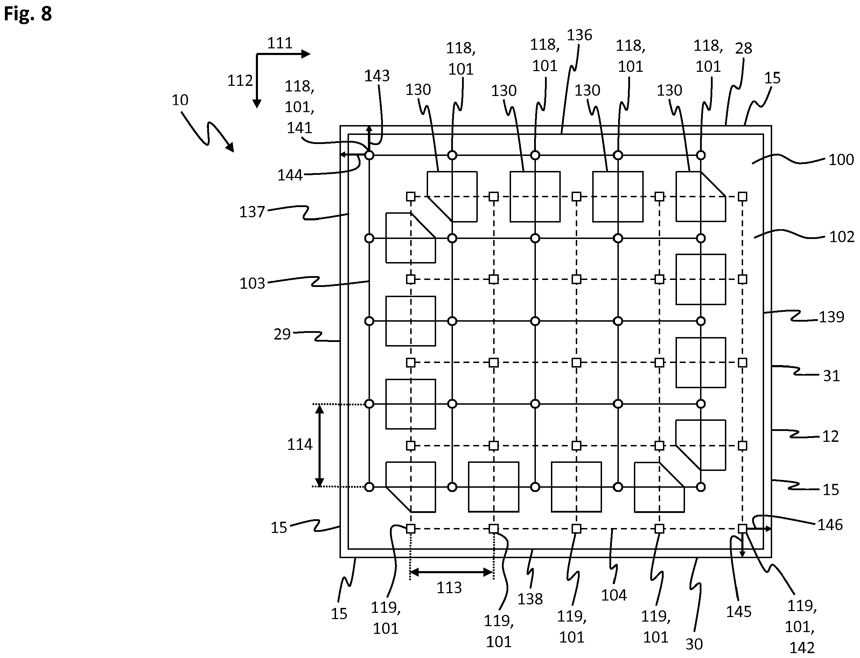

Fig. 8 zeigt8 zeigt in vereinfachter schematischer Darstellung einen Schnitt durch das Statormodulgehäuse 12 an der Schnittebene 27 der Fig. 6 Auf dieser Ebene ist innerhalb des Statormodulgehäuses 12 das Sensormodul 100 mit den Magnetfeldsensoren 101 auf dem Träger 102 angeordnet. Eine erste senkrechte Projektion 28 ist der ersten Seite 136 des Trägers 102 zugewandt. Eine zweite senkrechte Projektion 29 ist der zweiten Seite 137 des Trägers 102 zugewandt. Eine dritte senkrechte Projektion 30 ist der dritten Seite 138 des Trägers 102 zugewandt. Eine vierte senkrechte Projektion 31 ist der vierten Seite 139 des Trägers 102 zugewandt. Die erste bis vierte senkrechten Projektionen 28, 29, 30, 31 sind dabei senkrechte Projektionen der in der Fig.6 dargestellten Seiten 21, 22, 23, 24 der Statoroberfläche 11 in eine Magnetfeldsensorebene, wobei die Magnetfeldsensorebene durch die Magnetfeldsensoren 101 verläuft.

Das Statormodulgehäuse 12 und der Träger 102 sind quadratisch ausgeführt. Der ersten Projektion 28 der ersten Seite 21 der Statoroberfläche 11 ist die erste Seite 136 des Trägers 102 zugewandt. Der zweiten Projektion 29 der zweiten Seite 22 der Statoroberfläche 11 ist die zweite Seite 137 des Trägers 102 zugewandt. Der dritten Projektion 30 der dritten Seite 23 der Statoroberfläche 11 ist eine dritte Seite 138 des Trägers 102 zugewandt. Der vierten Projektion 31 der vierten Seite 24 der Statoroberfläche 11 ist eine vierte Seite 139 des Trägers 102 zugewandt. Außenkanten 15 des Statormodulgehäuses 12 können dabei direkt senkrecht unterhalb der vier Seiten 21, 22, 23, 24 der Statoroberfläche 11 angeordnet sein, wie in Fig. 6 gezeigt. Alternativ kann das Statormodulgehäuse 12 auch kleinere Abmessungen aufweisen, wobei dann die Statoroberfläche 11 über das Statormodulgehäuse 12 hinausragt.

Ein erster Eck-Magnetfeldsensor 141 der ersten Magnetfeldsensoren 118 ist unter dem in Fig. 6 dargestellten ersten Eckbereich 25 der Statoroberfläche 11 angeordnet und dem ersten Gitter 103 zugeordnet. Der erste Eck-Magnetfeldsensor 141 ist von der ersten Seite 21 der Statoroberfläche 11 in der zweiten Richtung 112 um ein Viertel des zweiten Abstands 114 versetzt angeordnet. Dies bedeutet, dass ein erster Vektor 143 parallel zur zweiten Richtung 112 vom ersten Eck-Magnetfeldsensor 141 zur ersten senkrechten Projektion 28 eine Länge von einem Viertel des zweiten Abstands 114 aufweist. Der erste Eck-Magnetfeldsensor 141 ist von der zweiten Seite 22 der Statoroberfläche 11 in der ersten Richtung 111 um ein Viertel des ersten Abstands 113 versetzt angeordnet. Dies bedeutet, dass ein zweiter Vektor 144 parallel zur ersten Richtung 111 vom ersten Eck-Magnetfeldsensor 141 zur zweiten senkrechten Projektion 29 eine Länge von einem Viertel des ersten Abstands 113 aufweist. Unterhalb des in Fig. 6 dargestellten zweiten Eckbereichs 26 der Statoroberfläche 11 ist ein zweiter Eck-Magnetfeldsensor 142 der zweiten Magnetfeldsensoren 119 angeordnet, der dem zweiten Gitter 104 zugeordnet ist. Der zweite Eck-Magnetfeldsensor 142 ist von der dritten Seite 23 der Statoroberfläche 11 in der zweiten Richtung 112 um ein Viertel des zweiten Abstands 114 versetzt angeordnet. Dies bedeutet, dass ein dritter Vektor 145 parallel zur zweiten Richtung 112 vom zweiten Magnetfeldsensor 142 zur dritten senkrechten Projektion 30 eine Länge von einem Viertel des zweiten Abstands 114 aufweist. Der zweite Eck-Magnetfeldsensor 142 ist von der vierten Seite 24 der Statoroberfläche 11 in der ersten Richtung 111 um ein Viertel des ersten Abstands 113 versetzt angeordnet. Dies bedeutet, dass ein vierter Vektor 146 parallel zur ersten Richtung 111 vom zweiten Eck-Magnetfeldsensor 142 zur vierten senkrechten Projektion 31 eine Länge von einem Viertel des ersten Abstands 113 aufweist.

Die vier senkrechten Projektionen 28, 29, 30, 31 können mit Seitenflächen 15 des Statormodulgehäuses 12 übereinstimmen, wie in Fig. 8 gezeigt. Die Seitenflächen 15 können jedoch auch nach innen versetzt angeordnet sein, wenn das Statormodulgehäuse 12 kleiner ist als die Statoroberfläche.

Durch die Anordnung des ersten Eck-Magnetfeldsensors 141 unterhalb der ersten Ecke 25 und des zweiten Eck-Magnetfeldsensors 142 unterhalb der zweiten Ecke 26 mit den jeweils genannten Abständen von einem Viertel des ersten Abstands 113 beziehungsweise einem Viertel des zweiten Abstands 114 bezüglich der vier senkrechten Projektionen 28, 29, 30, 31 der vier Seiten 21, 22, 23, 24 der Statoroberfläche 11 sind das erste Gitter 103 und das zweite Gitter 104 so innerhalb des Statormodulgehäuses 12 ausgerichtet, dass das Statormodulgehäuse um 180° gedreht werden kann ohne dass sich die Positionen der Magnetfeldsensoren 101 insgesamt ändern. Durch die Drehung um 180° werden die ersten Magnetfeldsensoren 118 auf die Positionen der zweiten Magnetfeldsensoren 119 bewegt und umgekehrt. Dadurch wird das Statormodul 10 flexibler in seiner Einsatzfähigkeit.

Das in Fig. 8 gezeigte Statormodul 10 ist quadratisch. Die Abstände von erstem Eck-Magnetfeldsensor 141 beziehungsweise zweitem Eck-Magnetfeldsensor 142 zu den vier senkrechten Projektionen 28, 29, 30, 31 können jedoch ebenso bei rechteckigen oder parallelogrammförmigen Statoroberflächen vorgesehen werden.

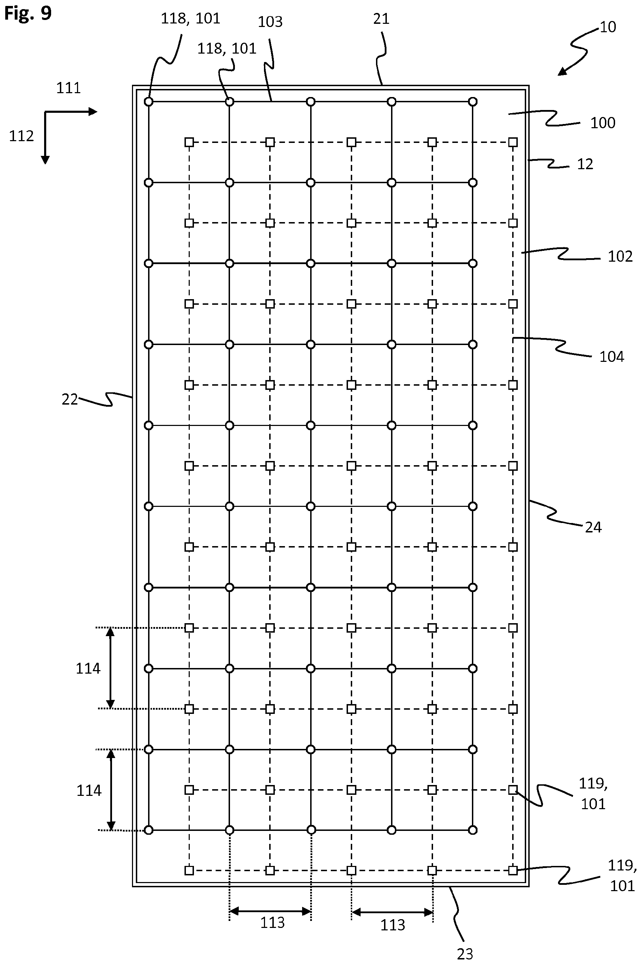

Fig. 9 zeigt in vereinfachter schematischer Darstellung einen Querschnitt durch ein Statormodul 10, welches, sofern im Folgenden keine Unterschiede beschrieben sind, dem Statormodul der Fig. 8 entspricht. Die Länge der ersten Seite 21 der Statoroberfläche entspricht dem Fünffachen des ersten Abstands 113 zwischen zwei benachbarten Magnetfeldsensoren 101 des ersten Gitters 103 oder des zweiten Gitters 104 in der ersten Richtung 111. Die Länge der zweiten Seite 22 der Statoroberfläche entspricht dem Zehnfachen des zweiten Abstands 114 zwischen zwei benachbarten Magnetfeldsensoren 101 des ersten Gitters 103 oder des zweiten Gitters 104 in der zweiten Richtung 112. Die Magnetfeldsensoren 101 sind wiederum so angeordnet, dass mehrere Statormodule 10 aneinandergereiht werden können. Ferner können einzelne Statormodule 10 wiederum um 180° gedreht werden, ohne dass sich die Anordnung der Magnetfeldsensoren 101 ändert.

Anstelle des Fünffachen des ersten Abstands 113 beziehungsweise des Zehnfachen des zweiten Abstands 114 können auch andere ganzzahlige Vielfache der zwei Abstände 113, 114 für die Länge der Seiten des Statormoduls 10 vorgesehen sein.

Ein Statormodul 10 wie in Fig. 9 gezeigt kann beispielsweise dann verwendet werden, wenn in einem Planarantriebssystem eine weitere Strecke in die zweite Richtung 112 zurückgelegt werden soll. Dann müssen nicht zwei Statormodule wie in Fig. 8 gezeigt aneinandergereiht werden, sondern es kann ein Statormodul wie in Fig. 9 gezeigt verwendet werden.

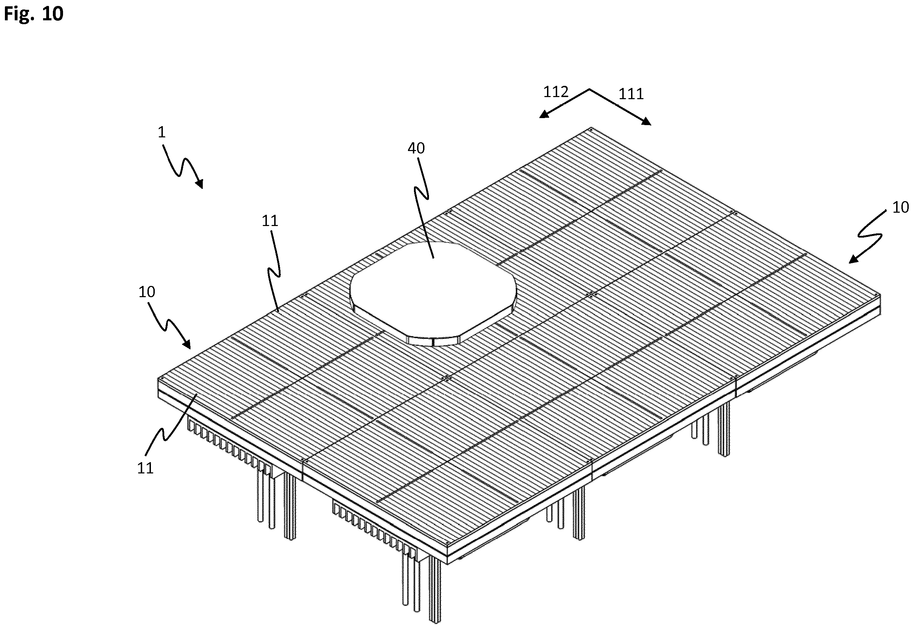

Fig. 10 zeigt ein Planarantriebssystem 1, bestehend aus mehreren Statormodulen 10, die wie in Fig. 6 bis 8 gezeigt aufgebaut sind, und einem oberhalb der Statoroberflächen 11 zumindest in die erste Richtung 111 sowie in die zweite Richtung 112 antreibbaren Läufer 40. Das erste Gitter und das zweite Gitter der Anordnungen von Magnetfeldsensoren der Sensormodule der Statormodule 10 setzen sich dabei über die gesamte Anordnung der Statormodule 10 fort. Es können auch weitere Statormodule 10 sowie mehrere Läufer 40 vorgesehen sein. Anstelle zweier benachbarter Statormodule 10 kann auch ein Statormodul wie in Fig. 9 gezeigt vorgesehen sein. Dies ist insbesondere dann sinnvoll, wenn in einer der beiden Richtungen 111, 112 weite Strecken zu überwinden sind. Es können auch Statormodule 10 mit weit mehr als zehn Magnetfeldsensoren in einer der zwei Richtungen 111, 112 vorgesehen sein.

Dadurch, dass die Statormodule 10 wie in den Fig. 6 bis 8 gezeigt aufgebaut sind, wobei der erste Eck-Magnetfeldsensor und der zweite Eck-Magnetfeldsensor die beschriebenen Abstände von jeweils einem Viertel von erstem Abstand beziehungsweise zweitem Abstand zu den Projektionen der Statoroberfläche 11 auf die Magnetfeldsensorebene aufweisen, setzen sich das erste Gitter und das zweite Gitter innerhalb der Statormodule 10 fort und es entsteht eine periodische Anordnung der Magnetfeldsensoren über Seiten der Statormodule 10 hinweg. Während der Positionserfassung können dann auch Magnetfeldsensoren zweier oder mehrerer Statormodule 10 verwendet werden.

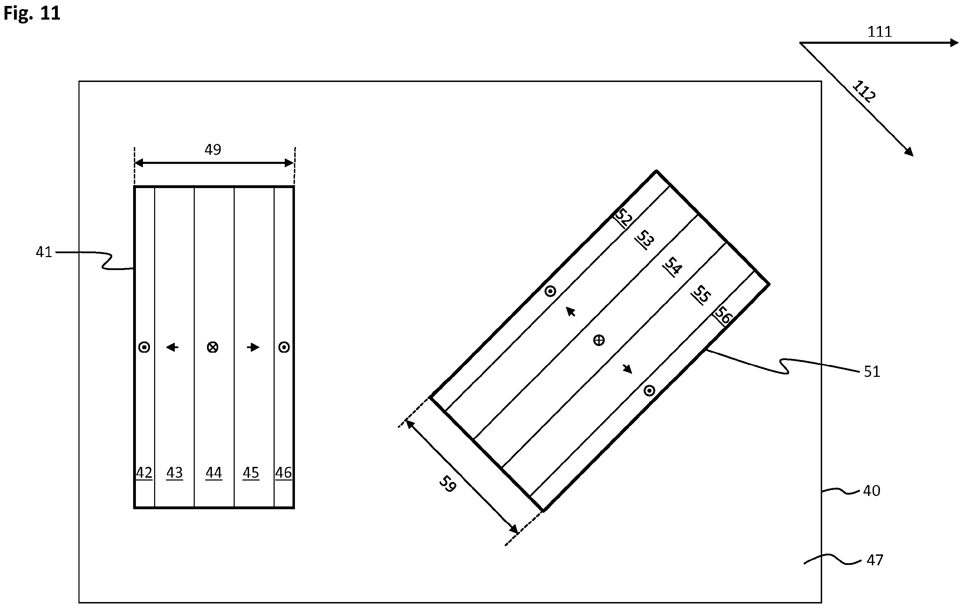

Fig. 11 zeigt eine Draufsicht von unten auf einen Läufer 40 für ein Planarantriebssystem. Es ist also eine einem Statormodul zugewandte planare Bodenfläche 47 des Läufers 40 gezeigt. Der Läufer 40 weist eine erste Magneteinheit 41 und eine zweite Magneteinheit 51 auf. Die erste Magneteinheit 41 weist fünf Magnetsegmente 42, 43, 44, 45, 46 auf, wobei die Magnetsegmente 42, 43, 44, 45, 46 in der ersten Richtung 111 nebeneinander angeordnet sind. Die erste Richtung 111 ist dabei während des Betriebs des Planarantriebssystems parallel zur ersten Richtung 111 eines der Sensormodule der bisher gezeigten Figuren ausgerichtet, sofern der Läufer 40 in einem Planarantriebssystem angetrieben wird. Alternativ kann die erste Magneteinheit 41 auch um einen Winkel von bis zu fünfzehn Grad gegenüber der ersten Richtung 111 abweichend angeordnet sein. Ein erstes Magnetsegment 42 ist neben einem zweiten Magnetsegment 43 angeordnet. Neben dem zweiten Magnetsegment 43, gegenüber dem ersten Magnetsegment 42, ist ein drittes Magnetsegment 44 angeordnet. Neben dem dritten Magnetsegment 44, gegenüber dem ersten Magnetsegment 42 und dem zweiten Magnetsegment 43, ist ein viertes Magnetsegment 45 angeordnet. Neben dem vierten Magnetsegment 45, gegenüber dem ersten Magnetsegment 42, dem zweiten Magnetsegment 43 und dem dritten Magnetsegment 44, ist ein fünftes Magnetsegment 46 angeordnet. Das erste Magnetsegment 42 sowie das fünfte Magnetsegment 46 sind dabei senkrecht zur ersten Richtung 111 sowie senkrecht zu der planaren Bodenfläche 47 des Läufers 40 magnetisiert. Ein daraus resultierendes Magnetfeld verläuft im ersten Magnetsegment 42 sowie im fünften Magnetsegment 46 aus der Zeichenebene der Fig. 11 heraus. Das dritte Magnetsegment 44 ist antiparallel zum ersten Magnetsegment 42 beziehungsweise dem fünften Magnetsegment 46 magnetisiert. Ein daraus resultierendes Magnetfeld verläuft im dritten Magnetsegment 44 in die Zeichenebene der Fig. 11 hinein. Das erste Magnetsegment 42 und das fünfte Magnetsegment 46 sind jeweils in der ersten Richtung 111 halb so breit wie das zweite Magnetsegment 43, das dritte Magnetsegment 44 sowie das vierte Magnetsegment 45.

Das zweite Magnetsegment 43 ist antiparallel zur ersten Richtung 111 magnetisiert. Das vierte Magnetsegment 45 ist parallel zur ersten Richtung 111 magnetisiert. Die Magnetisierung des zweiten Magnetsegments 43 und des vierten Magnetsegments 45 ist optional, alternativ können das zweite Magnetsegment 43 und das vierte Magnetsegment 45 auch unmagnetisiert vorliegen oder komplett entfallen.

Die erste Magneteinheit 41 ist periodisch fortsetzbar und weist aufgrund der Magnetisierung der fünf Magnetsegmente 42, 43, 44, 45, 46 einen Verlauf eines magnetischen Feldes auf. Würde eine weitere erste Magneteinheit 41 direkt an die erste Magneteinheit 41 angrenzend platziert, so würde sich der Verlauf des magnetischen Feldes periodisch fortsetzen. Eine erste Periodenlänge 49 der ersten Magneteinheit 41 entspricht einer Ausdehnung der ersten Magneteinheit 41 in der ersten Richtung 111. Die Magnetisierung der fünf Magnetsegmente 42, 43, 44, 45, 46 kann jeweils in Schritten von 90 Grad um eine Achse senkrecht zur ersten Richtung 111 und parallel zur Bodenfläche 47 gedreht werden, sofern dies für alle fünf Magnetsegmente 42, 43, 44, 45, 46 gleichzeitig erfolgt.

Die zweite Magneteinheit 51 weist fünf Magnetsegmente 52, 53, 54, 55, 56 auf, wobei die Magnetsegmente 52, 53, 54, 55, 56 in der zweiten Richtung 112 nebeneinander angeordnet sind. Die zweite Richtung 112 kann dabei während des Betriebs des Planarantriebssystems parallel zur zweiten Richtung 112 eines Sensormoduls ausgerichtet sein, sofern der Läufer 40 in einem Planarantriebssystem angetrieben wird. Alternativ kann die zweite Magneteinheit 51 auch um einen Winkel von bis zu fünfzehn Grad gegenüber der zweiten Richtung 112 abweichend angeordnet sein. Die ersten und zweiten Magneteinheiten 41, 51 können auch senkrecht zueinander stehen, insbesondere wenn die erste Richtung und die zweite Richtung der Anordnung von Magnetfeldsensoren des Sensormoduls ebenfalls senkrecht zueinander stehen. Dann können insbesondere die Sensormodule der Figuren 2 bis 5 sowie 8 und 9 zur Bestimmung der Position des Läufers 40 vorgesehen werden. Ein sechstes Magnetsegment 52 ist neben einem siebten Magnetsegment 53 angeordnet. Neben dem siebten Magnetsegment 53, gegenüber dem sechsten Magnetsegment 52, ist ein achtes Magnetsegment 54 angeordnet. Neben dem achten Magnetsegment 54, gegenüber dem sechsten Magnetsegment 52 und dem siebten Magnetsegment 53, ist ein neuntes Magnetsegment 55 angeordnet. Neben dem neunten Magnetsegment 55, gegenüber dem sechsten Magnetsegment 52, dem siebten Magnetsegment 53 und dem achten Magnetsegment 54, ist ein zehntes Magnetsegment 56 angeordnet. Das sechste Magnetsegment 52 sowie das zehnte Magnetsegment 56 sind dabei senkrecht zur zweiten Richtung 112 sowie senkrecht zur planaren Bodenfläche 47 des Läufers 40 magnetisiert. Ein daraus resultierendes Magnetfeld verläuft im sechsten Magnetsegment 52 sowie im zehnten Magnetsegment 56 aus der Zeichenebene der Fig. 11 heraus. Das achte Magnetsegment 54 ist antiparallel zum sechsten Magnetsegment 52 beziehungsweise dem zehnten Magnetsegment 56 magnetisiert. Ein daraus resultierendes Magnetfeld verläuft im achten Magnetsegment 54 in die Zeichenebene der Fig. 11 hinein. Das sechste Magnetsegment 52 und das zehnte Magnetsegment 56 sind jeweils in der zweiten Richtung 112 halb so breit wie das siebte Magnetsegment 53, das achte Magnetsegment 54 sowie das neunte Magnetsegment 55.

Das siebte Magnetsegment 53 ist antiparallel zur zweiten Richtung 112 magnetisiert. Das neunte Magnetsegment 55 ist parallel zur zweiten Richtung 112 magnetisiert. Die Magnetisierung des siebten Magnetsegments 53 und des neunten Magnetsegments 55 ist optional, alternativ können das siebte Magnetsegment 53 und das neunte Magnetsegment 55 auch unmagnetisiert vorliegen oder komplett entfallen.

Die zweite Magneteinheit 51 ist analog zur ersten Magneteinheit 41 periodisch fortsetzbar.

Die Magnetisierungen der fünf Magnetsegmente 42, 43, 44, 45, 46 der ersten Magneteinheit 41 sowie der fünf Magnetsegmente 52, 53, 54, 55, 56 der zweiten Magneteinheit 51 können mit den Magnetfeldsensoren eines der beschriebenen Sensormodule erfasst und daraus eine Position des Läufers 40 abgeleitet werden.

Die Magnetisierung der fünf Magnetsegmente 52, 53, 54, 55, 56 kann jeweils in Schritten von 90 Grad um eine Achse senkrecht zur zweiten Richtung 112 und parallel zur Bodenfläche 47 gedreht werden, sofern dies für alle fünf Magnetsegmente 52, 53, 54, 55, 56 gleichzeitig erfolgt.

Die erste und die zweite Magneteinheiten 41, 51 der Fig. 11 sind rechteckig ausgeführt. Alternativ können die erste und zweite Magneteinheiten 41, 51 auch in der Form eines Parallelogramms ausgeführt sein, wobei ein Winkel zwischen Parallelogrammseiten der ersten und zweiten Magneteinheiten 41, 51 einem Winkel zwischen der ersten Richtung 111 und der zweiten Richtung 112 entsprechen kann.

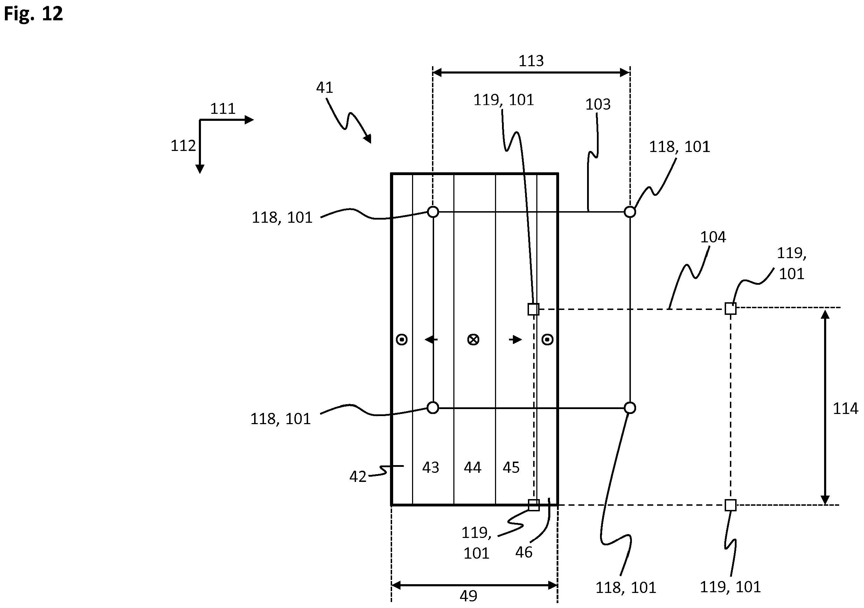

Fig. 12 zeigt zur Verdeutlichung des Messprinzips der Positionserfassung eine schematische Darstellung von einer Relativposition der ersten Magneteinheit 41 mit dem ersten bis fünften Magnetsegment 42, 43, 44, 45, 46 und mehreren Magnetfeldsensoren 101 eines Sensormoduls. Die Anordnung der Magnetfeldsensoren 101 entspricht dabei einer der in den Fig. 4, 5, 8 oder 9 gezeigten Anordnung, bei der zumindest bereichsweise die zweiten Magnetfeldsensoren 119 des zweiten Gitters 104 mittig zwischen den ersten Magnetfeldsensoren 118 des ersten Gitters 103 angeordnet sind. Die ersten Magnetfeldsensoren 118 sind rund beziehungsweise die zweiten Magnetfeldsensoren 119 sind eckig dargestellt. Der erste Abstand 113 und der zweite Abstand 114 betragen jeweils sechs Fünftel der ersten Periodenlänge 49 der ersten Magneteinheit 41. Eine Breite des zweiten Magnetsegments 43, des dritten Magnetsegments 44 sowie des vierten Magnetsegments 45 beträgt jeweils ein Viertel der ersten Periodenlänge 49. In Fig. 12 ist die Magneteinheit 41 bezüglich der ersten Richtung 111 in einer Position über den Magnetfeldsensoren 101 dargestellt, in der zwei erste Magnetfeldsensoren 118 des ersten Gitters 103 mittig unterhalb des zweiten Magnetsegments 43 angeordnet sind. Ein zweiter Magnetfeldsensor 119 des zweiten Gitters 104 ist aufgrund der Breite von jeweils einem Viertel der ersten Periodenlänge 49 der zweiten, dritten und vierten Magnetsegmente 43, 44, 45 sowie aufgrund der relativen Abstände der Magnetfeldsensoren 101 zueinander nicht mittig unter dem vierten Magnetsegment 45, sondern leicht in Richtung des fünften Magnetsegments 46 verschoben angeordnet. Dadurch messen die ersten Magnetfeldsensoren 118 des ersten Gitters 103 in dieser Position für eine Komponente parallel zur ersten Richtung 111 ein maximales Signal, während der zweite Magnetfeldsensor 119 des zweiten Gitters 104 unterhalb des vierten Magnetsegments 45 für diese Komponente kein maximales, sondern ein geringeres Signal misst. Wird der Läufer und damit die erste Magneteinheit 41 leicht nach rechts verschoben, so verschiebt sich das vierte Magnetsegment 45 direkt über den zweiten Magnetfeldsensor 119 des zweiten Gitters 104. Gleichzeitig bewegt sich jedoch auch das zweite Magnetsegment 43 weiter nach rechts, sodass dieses zweite Magnetsegment 43 nicht mehr direkt über den ersten Magnetfeldsensoren 118 des ersten Gitters 103 liegt. Nun misst der zweite Magnetfeldsensor 119 des zweiten Gitters 104 für die Komponente parallel zur ersten Richtung 111 ein maximales Signal, während die ersten Magnetfeldsensoren 118 des ersten Gitters 103 für diese Komponente ein geringeres Signal messen. Dadurch wird eine gute Abdeckung der Messwerte der Magnetisierung des Läufers, beziehungsweise der Magneteinheiten des Läufers erzielt.

Eine wie in Fig. 12 gezeigte relative Anordnung der Magnetfeldsensoren 101 des ersten Gitters 103 beziehungsweise zweiten Gitters 104 und der ersten Magneteinheit 41 zueinander ermöglicht eine Positionsbestimmung der ersten Magneteinheit 41 und damit des Läufers, in den die erste Magneteinheit 41 eingebaut ist. Die erste Magneteinheit 41 ist dabei in der ersten Richtung 111 ausgerichtet. Die zweite Magneteinheit des Läufers kann dabei analog zur ersten Magneteinheit 41 angeordnet sein, jedoch in der zweiten Richtung 112 ausgerichtet, und eine analoge Abdeckung mit Magnetfeldsensoren 101 des ersten Gitters 103 beziehungsweise zweiten Gitters 104 aufweisen.

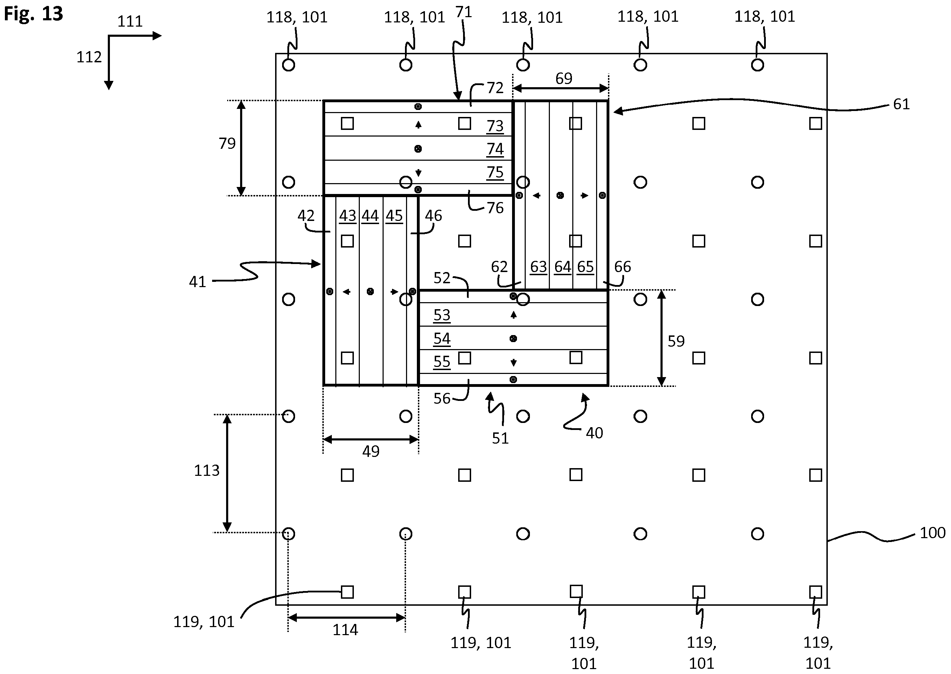

Fig. 13 zeigt zur Verdeutlichung des Messprinzips der Positionserfassung eine schematische Anordnung der Magnetfeldsensoren 101 mit den ersten Magnetfeldsensoren 118 in einem ersten Gitter 103 beziehungsweise mit den zweiten Magnetfeldsensoren 119 in einem zweiten Gitter 104 eines Sensormoduls 100 relativ zu einem Läufer 40, wobei die Anordnung der Magnetfeldsensoren 101 des Sensormoduls 100 der Anordnung der Magnetfeldsensoren der Fig. 4, 5 und 8 entspricht. Der Läufer 40 weist eine erste Magneteinheit 41 und eine zweite Magneteinheit 51 auf. Ferner weist der Läufer 40 eine dritte Magneteinheit 61 und eine vierte Magneteinheit 71 auf. Die vier Magneteinheiten 41, 51, 61 und 71 sind aufgebaut wie in Bezug auf die erste Magneteinheit 41 in Zusammenhang zu Fig. 11 beschrieben. Das Sensormodul 100 kann in ein Statormodul eingebaut sein, beispielsweise in das in den Figuren 6 bis 8 dargestellte Statormodul 10. Das Statormodul 10 und der Läufer 40 bilden ein Planarantriebssystem, bei dem der Läufer 40 wie in dem in Fig. 6 oder 10 gezeigten Ausführungsbeispiel oberhalb einer Statoroberfläche angetrieben werden kann. Eine Position des Läufers 40 kann mittels des Sensormoduls 100 ermittelt werden.

Die vier Magneteinheiten 41, 51, 61, 71 sind dabei jeweils aus fünf Magnetsegmenten aufgebaut, analog zu Fig. 12. Die vier Magneteinheiten 41, 51, 61, 71 sind in einem Viereck angeordnet. Die erste Magneteinheit 41 und die dritte Magneteinheit 61 sind dabei in gegenüberliegenden Ecken des Läufers 40 angeordnet, die zweite Magneteinheit 51 und die vierte Magneteinheit 71 sind ebenfalls in gegenüberliegenden Ecken des Läufers 40 angeordnet. Die erste Magneteinheit 41 weist eine erste Periodenlänge 49 auf. Die zweite Magneteinheit 51 weist eine zweite Periodenlänge 59 auf. Die dritte Magneteinheit 61 weist eine dritte Periodenlänge 69 auf. Die vierte Magneteinheit 71 weist eine vierte Periodenlänge 79 auf. Die dritte Periodenlänge 69 kann identisch zur ersten Periodenlänge 49 sein. Die vierte Periodenlänge 79 kann identisch zur zweiten Periodenlänge 59 sein. Die vier Periodenlängen 49, 59, 69, 79 der vier Magneteinheiten 41, 51, 61, 71 betragen jeweils fünf Sechstel des Abstands zwischen benachbarten Magnetfeldsensoren 101 des ersten Gitters 103 bzw. der zweiten Gitters 104, wie beispielsweise in Figur 2 dargestellt. Es können jedoch auch andere Werte für die Periodenlänge vorgesehen sein. Die erste Magneteinheit 41 ist aus einem ersten Magnetsegment 42, einem zweitem Magnetsegment 43, einem dritten Magnetsegment 44, einem vierten Magnetsegment 45 und einem fünften Magnetsegment 46 analog zur Fig. 11 aufgebaut. Die zweite Magneteinheit 51 ist aus einem sechsten Magnetsegment 52, einem siebten Magnetsegment 53, einem achten Magnetsegment 54, einem neunten Magnetsegment 55 sowie einem zehnten Magnetsegment 56, ebenfalls analog zur Fig. 11, aufgebaut. Die dritte Magneteinheit 61 ist aus einem elften Magnetsegment 62, einem zwölften Magnetsegment 63, einem dreizehnten Magnetsegment 64, einem vierzehnten Magnetsegment 65 sowie einem fünfzehnten Magnetsegment 66 aufgebaut. Die elften bis fünfzehnten Magnetsegmente 62, 63, 64, 65, 66 der dritten Magneteinheit 61 entsprechen dabei in Form und Magnetisierung den ersten bis fünften Magnetsegmenten 42, 43, 44, 45, 46 der ersten Magneteinheit 41. Die vierte Magneteinheit 71 ist aus einem sechzehnten Magnetsegment 72, einem siebzehnten Magnetsegment 73, einem achtzehnten Magnetsegment 74, einem neunzehnten Magnetsegment 75 sowie einem zwanzigsten Magnetsegment 76 aufgebaut. Die sechzehnten bis zwanzigsten Magnetsegmente 72, 73, 74, 75, 76 der vierten Magneteinheit 71 entsprechen dabei in Form und Magnetisierung den sechsten bis zehnten Magnetsegmenten 52, 53, 54, 55, 56 der zweiten Magneteinheit 51. Die Magnetisierung der Magnetsegmente 42, 43, 44, 45, 46, 62, 63, 64, 65, 66 der ersten Magneteinheit 41 beziehungsweise der dritten Magneteinheit 61 kann jeweils in Schritten von 90 Grad um eine Achse senkrecht zur ersten Richtung 111 und parallel zur Bodenfläche 47 gedreht werden, sofern dies für alle Magnetsegmente 42, 43, 44, 45, 46, 62, 63, 64, 65, 66 gleichzeitig erfolgt. Die Magnetisierung der Magnetsegmente 52, 53, 54, 55, 56, 72, 73, 74, 75, 76 des zweiten Magneteinheit 51 beziehungsweise der vierten Magneteinheit 71 kann jeweils in Schritten von 90 Grad um eine Achse senkrecht zur zweiten Richtung 112 und parallel zur Bodenfläche 47 gedreht werden, sofern dies für alle fünf Magnetsegmente 52, 53, 54, 55, 56, 72, 73, 74, 75, 76 gleichzeitig erfolgt.

Die in Fig. 13 dargestellte Position des Läufers 40 ist derart, dass unterhalb jeder der vier Magneteinheit 41, 51, 61, 71 jeweils drei Magnetfeldsensoren 101 angeordnet sind. Durch eine Bewegung des Läufers 40 kann es vorkommen, dass unter einer der vier Magneteinheiten 41, 51, 61, 71 zwei oder vier Magnetfeldsensoren 101 angeordnet sind. In der hier dargestellten Position des Läufers sind zwei zweite Magnetfeldsensoren 119 des zweiten Gitters 104 mittig unterhalb des zweiten Magnetsegments 43 angeordnet. Ein erster Magnetfeldsensor 118 des ersten Gitters 103 ist unter dem vierten Magnetsegment 45 angeordnet, jedoch nicht mittig unter dem vierten Magnetsegment 45, sondern in Richtung des fünften Magnetsegments 46 verschoben. Ein erster Magnetfeldsensor 118 des ersten Gitters 103 ist unter dem elften Magnetsegment 62 angeordnet. Zwei zweite Magnetfeldsensoren 119 des zweiten Gitters 104 sind unterhalb einer Grenze zwischen dem dreizehnten Magnetsegment 64 und dem vierzehnten Magnetsegment 65 angeordnet. Wird nun der Läufer 40 nach rechts, also in die erste Richtung 111 bewegt, verschieben sich die Magnetfeldsensoren 101 unterhalb der ersten Magneteinheit 41 und der dritten Magneteinheit 61 derart, dass regelmäßig Magnetfeldsensoren 101 mittig unterhalb der einzelnen Magnetsegmente 42, 43, 44, 45, 46, 62, 63, 64, 65, 66 der ersten und dritten Magneteinheit 41, 61 angeordnet sind und andere Magnetfeldsensoren 101 nicht mittig unterhalb der einzelnen Magnetsegmente 42, 43, 44, 45, 46, 62, 63, 64, 65, 66 der ersten und dritten Magneteinheit 41, 61 angeordnet sind. Dadurch kann die Position des Läufers 40 in der ersten Richtung 111 gut bestimmt werden, da aus einer Relation der Messwerte der Magnetfeldsensoren 101 mittig unterhalb der einzelnen Magnetsegmente 42, 43, 44, 45, 46, 62, 63, 64, 65, 66 der ersten und dritten Magneteinheit 41, 61 und nicht mittig unterhalb der einzelnen Magnetsegmente 42, 43, 44, 45, 46, 62, 63, 64, 65, 66 der ersten und dritten Magneteinheit 41, 61 eine gute Positionserfassung möglich wird.

Mittig unterhalb des siebzehnten Magnetsegments 73 sind ebenfalls zwei zweite Magnetfeldsensoren 119 des zweiten Gitters 104 angeordnet. Ein erster Magnetfeldsensor 118 des ersten Gitters 103 ist unterhalb einer Grenze zwischen dem neunzehnten Magnetsegment 75 und dem zwanzigsten Magnetsegment 76 angeordnet. Ein erster Magnetfeldsensor 118 des ersten Gitters 103 ist unterhalb des sechsten Magnetsegments 52 angeordnet. Zwei zweite Magnetfeldsensoren 119 des zweiten Gitters 104 sind unterhalbunterhalb des neunten Magnetsegments 55 angeordnet, jedoch nicht mittig unter dem neunten Magnetsegment 55, sondern in Richtung des achten Magnetsegments 54 verschoben. Wird nun der Läufer 40 nach unten, also in die zweite Richtung 112 bewegt, verschieben sich die Magnetfeldsensoren 101 unterhalb der zweiten Magneteinheit 51 und der vierten Magneteinheit 71 derart, dass regelmäßig Magnetfeldsensoren 101 mittig unterhalb der jeweiligen Magnetsegmente 52, 53, 54, 55, 56, 72, 73, 74, 75, 76 der zweiten und vierten Magneteinheit 51, 71 angeordnet sind und andere Magnetfeldsensoren 101 nicht mittig unterhalb der jeweiligen Magnetsegmente 52, 53, 54, 55, 56, 72, 73, 74, 75, 76 der zweiten und vierten Magneteinheit 51, 71 angeordnet sind. Dadurch kann die Position des Läufers 40 in der zweiten Richtung 112 gut bestimmt werden, da aus einer Relation der Messwerte der Magnetfeldsensoren 101 mittig unterhalb der jeweiligen Magnetsegmente 52, 53, 54, 55, 56, 72, 73, 74, 75, 76 der zweiten und vierten Magneteinheit 51, 71 und nicht mittig unterhalb der jeweiligen Magnetsegmente 52, 53, 54, 55, 56, 72, 73, 74, 75, 76 der zweiten und vierten Magneteinheit 51, 71 eine gute Positionserfassung möglich wird.

Um die Positionserfassung zu verbessern, ist also vorgesehen, dass in einer ersten Position des Läufers 40 einige Magnetfeldsensoren 101 mittig unterhalb von einigen der Magnetsegmente 42, 43, 44, 45, 46, 52, 53, 54, 55, 56, 62, 63, 64, 65, 66, 72, 73, 74, 75, 76 angeordnet sind, während andere Magnetfeldsensoren an anderen Positionen, insbesondere an Positionen, die sich zwischen den mittig unterhalb der Magnetsegmente 42, 43, 44, 45, 46, 52, 53, 54, 55, 56, 62, 63, 64, 65, 66, 72, 73, 74, 75, 76 befindlichen Positionen befinden, angeordnet sind. Durch kleine Verschiebungen des Läufers 40 sind die Magnetfeldsensoren 101, die in der ersten Position des Läufers 40 mittig unterhalb der Magnetsegmente 42, 43, 44, 45, 46, 52, 53, 54, 55, 56, 62, 63, 64, 65, 66, 72, 73, 74, 75, 76 angeordnet waren, nicht mehr mittig unter diesen Magnetsegmenten 42, 43, 44, 45, 46, 52, 53, 54, 55, 56, 62, 63, 64, 65, 66, 72, 73, 74, 75, 76 angeordnet. Dafür sind nun andere Magnetfeldsensoren 101 mittig unterhalb anderen Magnetsegmenten 42, 43, 44, 45, 46, 52, 53, 54, 55, 56, 62, 63, 64, 65, 66, 72, 73, 74, 75, 76 angeordnet. Dies ist insbesondere dann möglich, wenn die erste Periodenlänge 49 beziehungsweise die zweite Periodenlänge 59 keine ganzzahligen Vielfachen des ersten Abstands 113 beziehungsweise des zweiten Abstands 114 sind, sondern in einem rationalen Verhältnis zu erstem Abstand 113 beziehungsweise zweitem Abstand 114 stehen.

Ein Abstand zwischen der ersten Magneteinheit 41 und der dritten Magneteinheit 61 kann der ersten Periodenlänge 49 entsprechen. Ein Abstand zwischen der zweiten Magneteinheit 51 und der vierten Magneteinheit 71 kann der zweiten Periodenlänge 59 entsprechen.

Die erste Magneteinheit 41 grenzt an die zweite Magneteinheit 51 und die vierte Magneteinheit 71 an. Die zweite Magneteinheit 51 grenzt an die erste Magneteinheit 41 und die dritte Magneteinheit 61 an. Die dritte Magneteinheit 61 grenzt an die zweite Magneteinheit 51 und die vierte Magneteinheit 71 an. Die vierte Magneteinheit 71 grenzt an die erste Magneteinheit 41 und die dritte Magneteinheit 61 an.

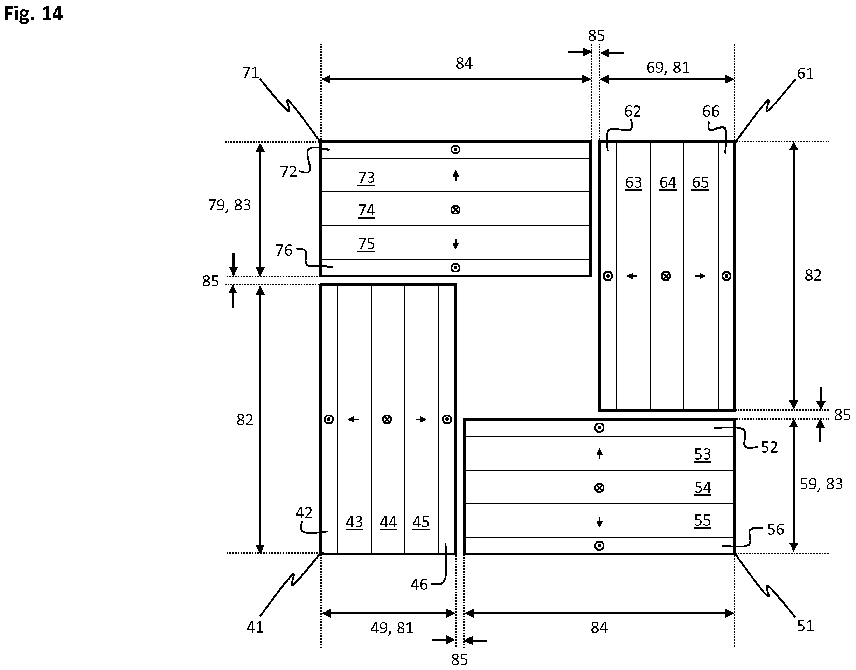

Alternativ dazu kann eine Anordnung der vier Magneteinheiten 41, 51, 61, 71 vorgesehen sein, wie sie in Fig. 14 gezeigt ist. Zwischen den vier Magneteinheiten 41, 51, 61, 71 sind Abstände 85 vorgesehen, welche jeweils ein Zwölftel der ersten, zweiten, dritten oder vierten Periodenlänge 49, 59, 69, 79 betragen. Die vier Magneteinheiten 41, 51, 61, 71 sind aus einzelnen Magnetsegmenten 42, 43, 44, 45, 46, 52, 53, 54, 55, 56, 62, 63, 64, 65, 66, 72, 73, 74, 75, 76 analog zu Fig. 12 aufgebaut. Die erste Magneteinheit 41 weist eine erste Ausdehnung 81 auf, welche der ersten Periodenlänge 49 der ersten Magneteinheit 41 entspricht. Die erste Magneteinheit 41 ist dabei rechteckig ausgebildet und eine zweite Ausdehnung 82 beträgt das Doppelte der zweiten Periodenlänge 59 der zweiten Magneteinheit 51. Die zweite Magneteinheit 51 weist eine dritte Ausdehnung 83 auf, die der zweiten Periodenlänge 59 entspricht. Eine vierte Ausdehnung 84 der zweiten Magneteinheit 51, welche ebenfalls rechteckig ausgeführt ist, beträgt das Doppelte der ersten Periodenlänge 49 der ersten Magneteinheit 41. Die dritte Magneteinheit 61 weist die erste Ausdehnung 81 und die zweite Ausdehnung 82 analog zur ersten Magneteinheit 41 auf. Die vierte Magneteinheit 71 weist die dritte Ausdehnung 83 und die vierte Ausdehnung 84 analog zur zweiten Magneteinheit 51 auf. Ein solcher Läufer kann ebenfalls gut mittels des Positionserfassungssystems des Statormoduls bestimmt werden.

Der Läufer 40 der Fig. 13 kann ebenfalls die vier Ausdehnungen 81, 82, 83, 84 der vier Magneteinheiten 41, 51, 61, 71 wie in Fig. 14 gezeigt, aufweisen.

Es kann vorgesehen sein, dass das Planarantriebssystem um weitere, an das Statormodul angrenzende Statormodule analog zu Fig. 9 und um weitere Läufer ergänzt wird. Durch die Anordnung der Magnetfeldsensoren 101 im Statormodul derart, dass sich die Anordnung der Magnetfeldsensoren 101 beim Vorsehen weiterer Statormodule periodisch fortsetzt, kann eine gute Positionsbestimmung des Läufers 40 auch über mehrere Statormodule hinweg erfolgen. Ebenso kann die Position mehrerer Läufer dadurch gut ermittelt werden.

Die gezeigten Ausführungsbeispiele können miteinander kombiniert werden ohne den Schutzumfang der Erfindung zu verlassen.

### Bezugszeichenliste:

- 1: Planarantriebssystem
- 10: Statormodul
- 11: Statoroberfläche
- 12: Statormodulgehäuse
- 14: Statoreinheit
- 15: Seitenflächen
- 16: Leiterstreifen
- 17: Leiterstreifenzwischenraum
- 20: Statormodul
- 21: erste Seite
- 22: zweite Seite
- 23: dritte Seite
- 24: vierte Seite
- 25: erster Eckbereich
- 26: zweiter Eckbereich
- 27: Schnittebene
- 28: erste senkrechte Projektion
- 29: zweite senkrechte Projektion
- 30: dritte senkrechte Projektion
- 31: vierte senkrechte Projektion
- 32: Leistungsmodul
- 33: Unterseite
- 34: Wärmeleitelement
- 35: Lüfter
- 36: Randbereich
- 37: mittlerer Bereich
- 40: Läufer
- 41: erste Magneteinheit
- 42: erstes Magnetsegment
- 43: zweites Magnetsegment
- 44: drittes Magnetsegment
- 45: viertes Magnetsegment
- 46: fünftes Magnetsegment
- 47: planare Bodenfläche
- 49: erste Periodenlänge
- 51: zweite Magneteinheit
- 52: sechstes Magnetsegment
- 53: siebtes Magnetsegment
- 54: achtes Magnetsegment
- 55: neuntes Magnetsegment
- 56: zehntes Magnetsegment
- 59: zweite Periodenlänge
- 61: dritte Magneteinheit
- 62: elftes Magnetsegment
- 63: zwölftes Magnetsegment
- 64: dreizehntes Magnetsegment
- 65: vierzehntes Magnetsegment
- 66: fünfzehntes Magnetsegment
- 69: dritte Periodenlänge
- 71: vierte Magneteinheit
- 72: sechzehntes Magnetsegment
- 73: siebzehntes Magnetsegment
- 74: achtzehntes Magnetsegment
- 75: neunzehntes Magnetsegment
- 76: zwanzigstes Magnetsegment
- 79: vierte Periodenlänge
- 81: erste Seitenkante
- 82: zweite Seitenkante
- 83: dritte Seitenkante
- 85: Abstand
- 100: Sensormodul
- 101: Magnetfeldsensoren
- 102: Träger
- 103: erstes periodisches Gitter
- 104: zweites periodisches Gitter
- 105: Mittelpunkt
- 106: Ausrichtungsloch
- 107: äußerer Bereich
- 108: innerer Bereich
- 109: schlitzförmige Erweiterung
- 110: zusätzliche Durchgangsöffnung
- 111: erste Richtung
- 112: zweite Richtung
- 113: erster Abstand
- 114: zweiter Abstand
- 115: Spalten
- 116: Reihen
- 118: erster Magnetfeldsensor
- 119: zweiter Magnetfeldsensor
- 120: Vektor
- 121: erste Komponente
- 122: zweite Komponente
- 125: erste Teilanordnung
- 126: zweite Teilanordnung
- 130: Durchgangsöffnung
- 131: erste Diagonale
- 132: zweite Diagonale
- 135: Steg
- 136: erste Seite
- 137: zweite Seite
- 138: dritte Seite
- 139: vierte Seite
- 141: erster Eck-Magnetfeldsensor
- 142: zweiter Eck-Magnetfeldsensor
- 143: erster Vektor
- 144: zweiter Vektor
- 145: dritter Vektor
- 146: vierter Vektor
- 151: erste Spalte des ersten Gitters
- 152: zweite Spalte des ersten Gitters
- 153: erste Reihe des ersten Gitters
- 154: zweite Reihe des ersten Gitters
- 151: vierte Spalte des zweiten Gitters
- 152: fünfte Spalte des zweiten Gitters
- 153: vierte Reihe des zweiten Gitters
- 154: fünfte Reihe des zweiten Gitters

## Patentansprüche

1. Planarantriebssystem (1), aufweisend einen Läufer (40) und ein Statormodul (10), wobei das Statormodul (10) ein Statormodulgehäuse (12), eine Statoreinheit (14) für einen elektrischen Antrieb des Läufers (40) und ein Sensormodul (100) zur Erfassung einer Position des Läufers (40) aufweist, wobei der Läufer (40) über einer ebenen Statoroberfläche (11) der Statoreinheit (14) zumindest in einer ersten Richtung (111) und in einer zweiten Richtung (112) antreibbar ist, wobei das Sensormodul (100) einen Träger (102) und eine zweidimensionale Anordnung von Magnetfeldsensoren (101) aufweist, wobei die Magnetfeldsensoren (101) auf dem Träger (102) angeordnet sind,
**dadurch gekennzeichnet, dass**
dass die zweidimensionale Anordnung von Magnetfeldsensoren (101) eine erste Teilanordnung (125) von ersten Magnetfeldsensoren (118) aufweist, dass die ersten Magnetfeldsensoren (118) der ersten Teilanordnung (125) in einem ersten periodischen Gitter (103) angeordnet sind, dass die ersten Magnetfeldsensoren (118) im ersten periodischen Gitter (103) entlang der ersten Richtung (111) und entlang der zweiten Richtung (112) angeordnet sind, dass benachbarte erste Magnetfeldsensoren (118) der ersten Teilanordnung (125) in der ersten Richtung (111) in einem ersten Abstand (113) zueinander angeordnet sind, dass benachbarte erste Magnetfeldsensoren (118) der ersten Teilanordnung in der zweiten Richtung (112) in einem zweiten Abstand (114) zueinander angeordnet sind, dass die zweidimensionale Anordnung von Magnetfeldsensoren (101) eine zweite Teilanordnung (126) von zweiten Magnetfeldsensoren (119) aufweist, dass die zweiten Magnetfeldsensoren (119) der zweiten Teilanordnung (126) in einem zweiten periodischen Gitter (104) angeordnet sind, dass die zweiten Magnetfeldsensoren (119) im zweiten periodischen Gitter (104) entlang der ersten Richtung (111) und entlang der zweiten Richtung (112) angeordnet sind, dass benachbarte zweite Magnetfeldsensoren (119) der zweiten Teilanordnung (126) in der ersten Richtung (111) im ersten Abstand (113) zueinander angeordnet sind, dass benachbarte zweite Magnetfeldsensoren (119) der zweiten Teilanordnung (126) in der zweiten Richtung (112) im zweiten Abstand (114) zueinander angeordnet sind, dass die erste Teilanordnung (125) und die zweite Teilanordnung (126) zueinander um einen Vektor (120) verschoben angeordnet sind, dass der Vektor (120) eine erste Komponente (121) in der ersten Richtung (111) und eine zweite Komponente (122) in der zweiten Richtung (112) aufweist, dass die erste Komponente (121) kleiner als der erste Abstand (113) ist, dass die zweite Komponente (122) kleiner als der zweite Abstand (114) ist, dass der Läufer (40) eine erste Magneteinheit (41) aufweist, dass die erste Magneteinheit (41) eine erste periodische Anordnung von Magneten mit einer ersten Periodenlänge (49) aufweist, dass die erste periodische Anordnung von Magneten in der ersten Richtung (111) periodisch ist, dass die erste Magneteinheit (41) während des Betriebs des Planarantriebssystems (1) in der ersten Richtung (111) ausgerichtet ist, dass der Läufer (40) eine zweite Magneteinheit (51) aufweist, dass die zweite Magneteinheit (51) eine zweite periodische Anordnung von Magneten mit einer zweiten Periodenlänge (59) aufweist, dass die zweite periodische Anordnung von Magneten in der zweiten Richtung (112) periodisch ist, dass die zweite Magneteinheit (51) während des Betriebs des Planarantriebssystems (1) in der zweiten Richtung (112) ausgerichtet ist, dass die erste Komponente (121) kleiner als die erste Periodenlänge (49) ist, dass eine Differenz aus dem ersten Abstand (113) und der ersten Komponente (121) kleiner als die erste Periodenlänge (49) ist, dass die zweite Komponente (122) kleiner als die zweite Periodenlänge (59) ist, dass eine Differenz aus dem zweiten Abstand (114) und der zweiten Komponente (122) kleiner als die zweite Periodenlänge (59) ist, dass die Statoreinheit (14) an einer Oberseite des Statormodulgehäuses (12) angeordnet ist, dass der Träger (102) unterhalb der Statoreinheit (14) im Statormodulgehäuse (12) angeordnet ist, dass der Träger (102) eine Durchgangsöffnung (130) aufweist, dass das Statormodulgehäuse (12) eine Wärmeleitstruktur (34) aufweist, dass die Wärmeleitstruktur (34) eingerichtet ist, Wärme von der Statoreinheit (14) weg zu einer der Statoroberfläche (11) gegenüberliegenden Unterseite (33) des Statormodulgehäuses (12) zu leiten, dass die Wärmeleitstruktur (34) von der Statoreinheit (14) durch die Durchgangsöffnung (130) zur Unterseite (33) des Statormodulgehäuses (12) geführt ist, dass die Durchgangsöffnung (130) an vier Magnetfeldsensoren (101) angrenzt, dass davon jeweils zwei erste Magnetfeldsensoren (118) zur ersten Teilanordnung (125) und jeweils zwei zweite Magnetfeldsensoren (119) zur zweiten Teilanordnung (126) zugeordnet sind.

2. Planarantriebssystem (1) nach Anspruch 1, wobei die erste Periodenlänge (49) ein Produkt aus einer ersten rationalen Zahl und dem ersten Abstand (113) ist, wobei die zweite Periodenlänge (59) ein Produkt aus einer zweiten rationalen Zahl und dem zweiten Abstand (114) ist und wobei die erste rationale Zahl und die zweite rationale Zahl zwischen 0,5 und 1 sind.

3. Planarantriebssystem (1) nach Anspruch 2, wobei die erste rationale Zahl fünf Sechstel ist und wobei die zweite rationale Zahl fünf Sechstel ist.

4. Planarantriebssystem (1) nach einem der Ansprüche 1 bis 3, wobei die erste Komponente (121) dem halben ersten Abstand (113) entspricht und wobei die zweite Komponente (122) dem halben zweiten Abstand (114) entspricht.

5. Planarantriebssystem (1) nach einem der Ansprüche 1 bis 4, wobei der erste Abstand (113) und der zweite Abstand (114) gleich groß sind.

6. Planarantriebssystem (1) nach einem der Ansprüche 1 bis 5, wobei die erste Richtung (111) und die zweite Richtung (112) senkrecht zueinander stehen.

7. Planarantriebssystem (1) nach einem der Ansprüche 1 bis 6, wobei die Statoroberfläche (11) ein Parallelogramm ist, wobei eine Länge einer ersten Parallelogrammseite der Statoroberfläche (11) ein erstes ganzzahliges Vielfaches des ersten Abstands (113) ist, wobei eine Länge einer zweiten Parallelogrammseite der Statoroberfläche (11) ein zweites ganzzahliges Vielfaches des zweiten Abstands (114) ist, wobei die erste Parallelogrammseite parallel zur ersten Richtung (111) ausgerichtet ist und wobei die zweite Parallelogrammseite parallel zur zweiten Richtung (112) ausgerichtet ist.

8. Planarantriebssystem (1) nach Anspruch 7, wobei das erste ganzzahlige Vielfache und das zweite ganzzahlige Vielfache identisch sind.

9. Planarantriebssystem (1) nach einem der Ansprüche 7 oder 8, wobei der Träger (102) derart angeordnet ist, dass ein erster Eck-Magnetfeldsensor (141) der ersten Teilanordnung (125) unter einem ersten Eckbereich (25) der Statoroberfläche (11) angeordnet ist, wobei der erste Eckbereich (25) der Statoroberfläche (11) an einem Schnittpunkt von erster Parallelogrammseite und zweiter Parallelogrammseite angeordnet ist, wobei der erste Eck-Magnetfeldsensor (141) in der ersten Richtung (111) um ein Viertel des ersten Abstands (113) von der zweiten Parallelogrammseite der Statoroberfläche (11) entfernt platziert ist, wobei der erste Eck-Magnetfeldsensor (141) in der zweiten Richtung (112) um ein Viertel des zweiten Abstands (114) von der ersten Parallelogrammseite der Statoroberfläche (11) entfernt platziert ist, wobei ein zweiter Eck-Magnetfeldsensor (142) der zweiten Teilanordnung (126) in einem dem ersten Eckbereich (25) gegenüberliegenden zweiten Eckbereich (26) der Statoroberfläche (11) angeordnet ist, wobei der zweite Eckbereich (26) der Statoroberfläche (11) an einem Schnittpunkt von einer dritten Parallelogrammseite und einer vierten Parallelogrammseite angeordnet ist, wobei der zweite Eck-Magnetfeldsensor (142) in der ersten Richtung (111) um ein Viertel des ersten Abstands (113) von der vierten Parallelogrammseite der Statoroberfläche (11) entfernt platziert ist, wobei die vierte Parallelogrammseite der zweiten Parallelogrammseite gegenüberliegt, wobei der zweite Eck-Magnetfeldsensor (142) in der zweiten Richtung (112) um ein Viertel des zweiten Abstands (114) von der dritten Parallelogrammseite der Statoroberfläche (11) entfernt platziert ist, wobei die dritte Parallelogrammseite der ersten Parallelogrammseite gegenüberliegt.

10. Statormodul (10) für ein Planarantriebssystem (1), aufweisend ein Statormodulgehäuse (12) und eine Statoreinheit (14) für einen elektrischen Antrieb eines Läufers (40) und ein Sensormodul (100) zur Erfassung einer Position des Läufers (40), wobei der Läufer (40) über einer ebenen Statoroberfläche (11) der Statoreinheit (14) zumindest in einer ersten Richtung (111) und einer zweiten Richtung (112) antreibbar ist, wobei das Sensormodul (100) einen Träger (102) und eine zweidimensionale Anordnung von Magnetfeldsensoren (101) aufweist, wobei die Magnetfeldsensoren (101) auf dem Träger (102) angeordnet sind,
**dadurch gekennzeichnet, dass**
dass die zweidimensionale Anordnung von Magnetfeldsensoren (101) eine erste Teilanordnung (126) von ersten Magnetfeldsensoren (118) aufweist, dass die ersten Magnetfeldsensoren (118) der ersten Teilanordnung (125) in einem ersten periodischen Gitter (103) angeordnet sind, dass die ersten Magnetfeldsensoren (118) im ersten periodischen Gitter (103) entlang der ersten Richtung (111) und entlang der zweiten Richtung (112) angeordnet sind, dass benachbarte erste Magnetfeldsensoren (118) der ersten Teilanordnung (125) in der ersten Richtung (111) in einem ersten Abstand (113) zueinander angeordnet sind, dass benachbarte erste Magnetfeldsensoren (118) der ersten Teilanordnung (125) in der zweiten Richtung (112) in einem zweiten Abstand (114) zueinander angeordnet sind, dass die zweidimensionale Anordnung von Magnetfeldsensoren (101) eine zweite Teilanordnung (126) von zweiten Magnetfeldsensoren (119) aufweist, dass die zweiten Magnetfeldsensoren (119) der zweiten Teilanordnung (126) in einem zweiten periodischen Gitter (104) angeordnet sind, dass die zweiten Magnetfeldsensoren (119) im zweiten periodischen Gitter (104) entlang der ersten Richtung (111) und entlang der zweiten Richtung (112) angeordnet sind, dass benachbarte zweite Magnetfeldsensoren (119) der zweiten Teilanordnung (126) in der ersten Richtung (111) im ersten Abstand (113) zueinander angeordnet sind, dass benachbarte zweite Magnetfeldsensoren (119) der zweiten Teilanordnung (126) in der zweiten Richtung (112) im zweiten Abstand (114) zueinander angeordnet sind, dass die erste Teilanordnung (125) und die zweite Teilanordnung (126) zueinander um einen Vektor verschoben angeordnet sind, dass der Vektor eine erste Komponente (121) in der ersten Richtung (111) und eine zweite Komponente (122) in der zweiten Richtung (112) aufweist, dass die erste Komponente (121) kleiner als der erste Abstand (113) ist und dass die zweite Komponente (122) kleiner als der zweite Abstand (114) ist, dass die Statoreinheit (14) an einer Oberseite des Statormodulgehäuses (12) angeordnet ist, dass der Träger (102) unterhalb der Statoreinheit (14) im Statormodulgehäuse (12) angeordnet ist, dass der Träger (102) eine Durchgangsöffnung (130) aufweist, dass das Statormodulgehäuse (12) eine Wärmeleitstruktur (34) aufweist, dass die Wärmeleitstruktur (34) eingerichtet ist, Wärme von der Statoreinheit (14) weg zu einer der Statoroberfläche (11) gegenüberliegenden Unterseite (33) des Statormodulgehäuses (12) zu leiten, dass die Wärmeleitstruktur (34) von der Statoreinheit (14) durch die Durchgangsöffnung (130) zur Unterseite (33) des Statormodulgehäuses (12) geführt ist, dass die Durchgangsöffnung (130) an vier Magnetfeldsensoren (101) angrenzt, dass davon jeweils zwei erste Magnetfeldsensoren (118) zur ersten Teilanordnung (125) und jeweils zwei zweite Magnetfeldsensoren (119) zur zweiten Teilanordnung (126) zugeordnet sind.

11. Statormodul (10) nach Anspruch 10, wobei der Träger (102) eine Leiterplatte, insbesondere eine Platine, aufweist.

12. Statormodul (10) nach einem der Ansprüche 10 oder 11, wobei der Träger (102) mehrere Durchgangsöffnungen (130) und mehrere durch die Durchgangsöffnungen (130) geführte Wärmeleitelemente (34) aufweist, wobei die Durchgangsöffnungen (130) jeweils an vier Magnetfeldsensoren (101) angrenzen, wobei davon jeweils zwei erste Magnetfeldsensoren (118) zur ersten Teilanordnung (125) und jeweils zwei zweite Magnetfeldsensoren (119) zur zweiten Teilanordnung (126) zugeordnet sind.

13. Statormodul (10) nach einem der Ansprüche 10 bis 12, wobei der Träger (102) einen inneren Bereich (108) und einen äußeren Bereich (107) aufweist, wobei der äußere Bereich (107) ringförmig um den inneren Bereich (108) angeordnet ist, wobei die Durchgangsöffnung (130) oder die Durchgangsöffnungen (130) im äußeren Bereich (107) angeordnet sind, wobei der äußere Bereich (107) mindestens 50 Prozent einer Fläche des Sensormoduls (100) umfasst.

14. Statormodul (10) nach einem der Ansprüche 10 bis 13, wobei die Anordnung von Magnetfeldsensoren (101) genau zwei Teilanordnungen (125, 126) von Magnetfeldsensoren (101) umfasst.

15. Sensormodul (100) zur Erfassung einer Position eines Läufers (40) in einem Planarantriebssystem (1), wobei das Sensormodul (100) einen Träger (102) und eine zweidimensionale Anordnung von Magnetfeldsensoren (101) aufweist, wobei die Magnetfeldsensoren (101) auf dem Träger (102) angeordnet sind, wobei die zweidimensionale Anordnung von Magnetfeldsensoren (101) eine erste Teilanordnung (125) von ersten Magnetfeldsensoren (118) aufweist, wobei die ersten Magnetfeldsensoren (118) der ersten Teilanordnung (125) in einem ersten periodischen Gitter (103) angeordnet sind, wobei die ersten Magnetfeldsensoren (118) im ersten periodischen Gitter (103) in einer ersten Richtung (111) und in einer zweiten Richtung (112) angeordnet sind, wobei benachbarte erste Magnetfeldsensoren (118) der ersten Teilanordnung (125) entlang der ersten Richtung (111) in einem ersten Abstand (113) zueinander angeordnet sind, wobei benachbarte erste Magnetfeldsensoren (118) der ersten Teilanordnung (125) entlang der zweiten Richtung (112) in einem zweiten Abstand (114) zueinander angeordnet sind,
**dadurch gekennzeichnet, dass**,
dass die zweidimensionale Anordnung von Magnetfeldsensoren (101) eine zweite Teilanordnung (126) von zweiten Magnetfeldsensoren (119) aufweist, dass die zweiten Magnetfeldsensoren (119) der zweiten Teilanordnung (126) in einem zweiten periodischen Gitter (104) angeordnet sind, dass die zweiten Magnetfeldsensoren (119) im zweiten periodischen Gitter (104) in der ersten Richtung (111) und in der zweiten Richtung (112) angeordnet sind, dass benachbarte zweite Magnetfeldsensoren (119) der zweiten Teilanordnung (126) entlang der ersten Richtung (111) im ersten Abstand (113) zueinander angeordnet sind, dass benachbarte zweite Magnetfeldsensoren (119) der zweiten Teilanordnung (126) entlang der zweiten Richtung (112) im zweiten Abstand (114) zueinander angeordnet sind, dass die erste Teilanordnung (125) und die zweite Teilanordnung (126) zueinander um einen Vektor verschoben angeordnet sind, dass der Vektor eine erste Komponente (121) in der ersten Richtung (111) und eine zweite Komponente (122) in der zweiten Richtung (112) aufweist, dass die erste Komponente (121) kleiner als der erste Abstand (113) ist und dass die zweite Komponente (122) kleiner als der zweite Abstand (114) ist, dass der Träger (102) eine Durchgangsöffnung (130) für eine Wärmeleitstruktur (34) aufweist, dass die Durchgangsöffnung (130) an vier Magnetfeldsensoren (101) angrenzt, dass davon jeweils zwei erste Magnetfeldsensoren (118) zur ersten Teilanordnung (125) und jeweils zwei zweite Magnetfeldsensoren (119) zur zweiten Teilanordnung (126) zugeordnet sind.

## Claims

1. Planar drive system (1), having a rotor (40) and a stator module (10), wherein the stator module (10) has a stator module housing (12), a stator unit (14) for an electric drive of the rotor (40), and a sensor module (100) for sensing a position of the rotor (40), wherein the rotor (40) can be driven at least in a first direction (111) and in a second direction (112) via a planar stator surface (11) of the stator unit (14), wherein the sensor module (100) has a carrier (102) and a two-dimensional arrangement of magnetic field sensors (101), wherein the magnetic field sensors (101) are arranged on the carrier (102),
**characterized**
**in that** the two-dimensional arrangement of magnetic field sensors (101) has a first part-arrangement (125) of first magnetic field sensors (118), in that the first magnetic field sensors (118) of the first part-arrangement (125) are arranged in a first periodic grating (103), in that the first magnetic field sensors (118) are arranged in the first periodic grating (103) along the first direction (111) and along the second direction (112), in that adjacent first magnetic field sensors (118) of the first part-arrangement (125) are arranged at a first distance (113) from one another in the first direction (111), in that adjacent first magnetic field sensors (118) of the first part-arrangement are arranged at a second distance (114) from one another in the second direction (112), in that the two-dimensional arrangement of magnetic field sensors (101) has a second part-arrangement (126) of second magnetic field sensors (119), in that the second magnetic field sensors (119) of the second part-arrangement (126) are arranged in a second periodic grating (104), in that the second magnetic field sensors (119) are arranged in the second periodic grating (104) along the first direction (111) and along the second direction (112), in that adjacent second magnetic field sensors (119) of the second part-arrangement (126) are arranged at the first distance (113) from one another in the first direction (111), in that adjacent second magnetic field sensors (119) of the second part-arrangement (126) are arranged at the second distance (114) from one another in the second direction (112), in that the first part-arrangement (125) and the second part-arrangement (126) are arranged shifted with respect to one another by a vector (120), in that the vector (120) has a first component (121) in the first direction (111) and a second component (122) in the second direction (112), in that the first component (121) is smaller than the first distance (113), in that the second component (122) is smaller than the second distance (114), in that the rotor (40) has a first magnet unit (41), in that the first magnet unit (41) has a first periodic arrangement of magnets with a first period length (49), in that the first periodic arrangement of magnets in the first direction (111) is periodic, in that while the planar drive system (1) is operating the first magnet unit (41) is oriented in the first direction (111), in that the rotor (40) has a second magnet unit (51), in that the second magnet unit (51) has a second periodic arrangement of magnets with a second period length (59), in that the second periodic arrangement of magnets in the second direction (112) is periodic, in that while the planar drive system (1) is operating the second magnet unit (51) is oriented in the second direction (112), in that the first component (121) is smaller than the first period length (49), in that a difference between the first distance (113) and the first component (121) is smaller than the first period length (49), in that the second component (122) is smaller than the second period length (59), in that a difference between the second distance (114) and the second component (122) is smaller than the second period length (59), in that the stator unit (14) is arranged on an upper side of the stator module housing (12), in that the carrier (102) is arranged underneath the stator unit (14) in the stator module housing (12), in that the carrier (102) has a through-opening (130), in that the stator module housing (12) has a heat-conducting structure (34), in that the heat-conducting structure (34) is configured to conduct heat away from the stator unit (14) to an underside (33), lying opposite the stator surface (11), of the stator module housing (12), in that the heat-conducting structure (34) is made to extend from the stator unit (14) through the through-opening (130) to the underside (33) of the stator module housing (12), in that the through-opening (130) adjoins four magnetic field sensors (101), and in that in each case two first magnetic field sensors (118) thereof are assigned to the first part-arrangement (125), and in each case two second magnetic field sensors (119) thereof are assigned to the second part-arrangement (126).

2. Planar drive system (1) according to Claim 1, wherein the first period length (49) is a product of a first rational number and the first distance (113), wherein the second period length (59) is a product of a second rational number and the second distance (114), and wherein the first rational number and the second rational number are between 0.5 and 1.

3. Planar drive system (1) according to Claim 2, wherein the first rational number is five sixths, and wherein the second rational number is five sixths.

4. Planar drive system (1) according to one of Claims 1 to 3, wherein the first component (121) corresponds to half the first distance (113), and wherein the second component (122) corresponds to half the second distance (114).

5. Planar drive system (1) according to one of Claims 1 to 4, wherein the first distance (113) and the second distance (114) are of equal magnitude.

6. Planar drive system (1) according to one of Claims 1 to 5, wherein the first direction (111) and the second direction (112) are perpendicular to one another.

7. Planar drive system (1) according to one of Claims 1 to 6, wherein the stator surface (11) is a parallelogram, wherein a length of a first parallelogram side of the stator surface (11) is a first integral multiple of the first distance (113), with a length of a second parallelogram side of the stator surface (11) is a second integral multiple of the second distance (114), wherein the first parallelogram side is oriented parallel to the first direction (111), and wherein the second parallelogram side is oriented parallel to the second direction (112).

8. Planar drive system (1) according to Claim 7, wherein the first integral multiple and the second integral multiple are identical.

9. Planar drive system (1) according to either of Claims 7 and 8, wherein the carrier (102) is arranged in such a way that a first corner magnetic field sensor (141) of the first part-arrangement (125) is arranged under a first corner region (25) of the stator surface (11), wherein the first corner region (25) of the stator surface (11) is arranged at an intersection point of the first parallelogram side and the second parallelogram side, wherein the first corner magnetic field sensor (141) is positioned a quarter of the first distance (113) away from the second parallelogram side of the stator surface (11) in the first direction (111), wherein the first corner magnetic field sensor (141) is positioned a quarter of the second distance (114) away from the first parallelogram side of the stator surface (11) in the second direction (112), wherein a second corner magnetic field sensor (142) of the second part-arrangement (126) is arranged in a second corner region (26), opposite the first corner region (25), of the stator surface (11), wherein the second corner region (26) of the stator surface (11) is arranged at an intersection point of a third parallelogram side and a fourth parallelogram side, wherein the second corner magnetic field sensor (142) is positioned a quarter of the first distance (113) away from the fourth parallelogram side of the stator surface (11) in the first direction (111), wherein the fourth parallelogram side is opposite the second parallelogram side, wherein the second corner magnetic field sensor (142) is positioned a quarter of the second distance (114) away from the third parallelogram side of the stator surface (11) in the second direction (1112), wherein the third parallelogram side is opposite the first parallelogram side.

10. Stator module (10) for a planar drive system (1), having a stator module housing (12) and a stator unit (14) for an electric drive of a rotor (40), and a sensor module (100) for sensing a position of the rotor (40), wherein the rotor (40) can be driven at least in a first direction (111) and a second direction (112) via a planar stator surface (11) of the stator unit (14), wherein the sensor module (100) has a carrier (102) and a two-dimensional arrangement of magnetic field sensors (101), wherein the magnetic field sensors (101) are arranged on the carrier (102),
**characterized**
**in that** the two-dimensional arrangement of magnetic field sensors (101) has a first part-arrangement (126) of first magnetic field sensors (118), in that the first magnetic field sensors (118) of the first part-arrangement (125) are arranged in a first periodic grating (103), in that the first magnetic field sensors (118) are arranged in the first periodic grating (103) along the first direction (111) and along the second direction (112), in that adjacent first magnetic field sensors (118) of the first part-arrangement (125) are arranged at a first distance (113) from one another in the first direction (111), in that adjacent first magnetic field sensors (118) of the first part-arrangement (125) are arranged at a second distance (114) from one another in the second direction (112), in that the two-dimensional arrangement of magnetic field sensors (101) has a second part-arrangement (126) of second magnetic field sensors (119), in that the second magnetic field sensors (119) of the second part-arrangement (126) are arranged in a second periodic grating (104), in that the second magnetic field sensors (119) are arranged in the second periodic grating (104) along the first direction (111) and along the second direction (112), in that adjacent second magnetic field sensors (119) of the second part-arrangement (126) are arranged at the first distance (113) from one another in the first direction (111), in that adjacent second magnetic field sensors (119) of the second part-arrangement (126) are arranged at the second distance (114) from one another in the second direction (112), in that the first part-arrangement (125) and the second part-arrangement (126) are arranged shifted with respect to one another by a vector, in that the vector has a first component (121) in the first direction (111) and a second component (122) in the second direction (112), in that the first component (121) is smaller than the first distance (113), and in that the second component (122) is smaller than the second distance (114), in that the stator unit (14) is arranged on an upper side of the stator module housing (12), in that the carrier (102) is arranged underneath the stator unit (14) in the stator module housing (12), in that the carrier (102) has a through-opening (130), in that the stator module housing (12) has a heat-conducting structure (34), in that the heat-conducting structure (34) is configured to conduct heat away from the stator unit (14) to an underside (33), opposite the stator surface (11), of the stator module housing (12), in that the heat-conducting structure (34) is made to extend from the stator unit (14) through the through-opening (130) to the underside (33) of the stator module housing (12), in that the through-opening (130) adjoins four magnetic field sensors (101), and in that in each case two first magnetic field sensors (118) thereof are assigned to the first part-arrangement (125), and in each case two second magnetic field sensors (119) thereof are assigned to the second part-arrangement (126).

11. Stator module (10) according to Claim 10, wherein the carrier (102) has a circuit board, in particular a printed circuit board.

12. Stator module (10) according to either of Claims 10 and 11, wherein the carrier (102) has a plurality of through-openings (130) and a plurality of heat-conducting elements (34) which are made to extend through the through-openings (130), wherein the through-openings (130) each adjoin four magnetic field sensors (101), wherein in each case two first magnetic field sensors (118) thereof are assigned to the first part-arrangement (125), and in each case two second magnetic field sensors (119) thereof are assigned to the second part-arrangement (126).

13. Stator module (10) according to one of Claims 10 to 12, wherein the carrier (102) has an inner region (108) and an outer region (107), wherein the outer region (107) is arranged in an annular shape around the inner region (108), wherein the through-opening (130) or the through-openings (130) is/are arranged in the outer region (107), wherein the outer region (107) comprises at least 50 per cent of the area of the sensor module (100).

14. Stator module (10) according to one of Claims 10 to 13, wherein the arrangement of magnetic field sensors (101) comprises precisely two part-arrangements (125, 126) of magnetic field sensors (101) .

15. Sensor module (100) for sensing a position of a rotor (40) in a planar drive system (1), wherein the sensor module (100) has a carrier (102) and a two-dimensional arrangement of magnetic field sensors (101), wherein the magnetic field sensors (101) are arranged on the carrier (102), wherein the two-dimensional arrangement of magnetic field sensors (101) has a first part-arrangement (125) of first magnetic field sensors (118), wherein the first magnetic field sensors (118) of the first part-arrangement (125) are arranged in a first periodic grating (103), wherein the first magnetic field sensors (118) are arranged in the first periodic grating (103) in a first direction (111) and in a second direction (112), wherein adjacent first magnetic field sensors (118) of the first part-arrangement (125) are arranged at a first distance (113) from one another along the first direction (111), wherein adjacent first magnetic field sensors (118) of the first part-arrangement (125) are arranged at a second distance (114) from one another along the second direction (112),
**characterized**
**in that** the two-dimensional arrangement of magnetic field sensors (101) has a second part-arrangement (126) of second magnetic field sensors (119), in that the second magnetic field sensors (119) of the second part-arrangement (126) are arranged in a second periodic grating (104), in that the second magnetic field sensors (119) are arranged in the second periodic grating (104) in the first direction (111) and in the second direction (112), in that adjacent second magnetic field sensors (119) of the second part-arrangement (126) are arranged at the first distance (113) from one another along the first direction (111), in that adjacent second magnetic field sensors (119) of the second part-arrangement (126) are arranged at the second distance (114) from one another along the second direction (112), in that the first part-arrangement (125) and the second part-arrangement (126) are arranged shifted with respect to one another by a vector, in that the vector has a first component (121) in the first direction (111) and a second component (122) in the second direction (112), in that the first component (121) is smaller than the first distance (113), and in that the second component (122) is smaller than the second distance (114), in that the carrier (102) has a through-opening (130) for a heat-conducting structure (34), in that the through-opening (130) adjoins four magnetic field sensors (101), and in that in each case two first magnetic field sensors (118) thereof are assigned to the first part-arrangement (125), and in each case two second magnetic field sensors (119) thereof are assigned to the second part-arrangement (126).

## Revendications

1. Système d'entraînement planaire (1), comportant un rotor (40) et un module de stator (10), le module de stator (10) comportant un boîtier de module de stator (12), une unité de stator (14) destinée à un entraînement électrique du rotor (40) et un module de capteur (100) destiné à détecter une position du rotor (40), le rotor (40) pouvant être entraîné au-dessus d'une surface de stator plane (11) du stator (14) au moins dans une première direction (111) et dans une deuxième direction (112), le module de capteur (100) comportant un support (102) et un ensemble bidimensionnel de capteurs de champ magnétique (101), les capteurs de champ magnétique (101) étant disposés sur le support (102),
**caractérisé en ce que**
l'ensemble bidimensionnel de capteurs de champ magnétique (101) comporte un premier sous-ensemble (125) de premiers capteurs de champ magnétique (118), **en ce que** les premiers capteurs de champ magnétique (118) du premier sous-ensemble (125) sont disposés suivant un premier réseau périodique (103), **en ce que** les premiers capteurs de champ magnétique (118) du premier réseau périodique (103) sont disposés le long de la première direction (111) et le long de la deuxième direction (112), **en ce que** des premiers capteurs de champ magnétique (118) adjacents du premier sous-ensemble (125) sont disposés dans la première direction (111) à une première distance (113) les uns des autres, **en ce que** des premiers capteurs de champ magnétique adjacents (118) du premier sous-ensemble sont disposés dans la deuxième direction (112) à une deuxième distance (114) les uns des autres, **en ce que** l'ensemble bidimensionnel de capteurs de champ magnétique (101) comporte un deuxième sous-ensemble (126) de deuxièmes capteurs de champ magnétique (119), **en ce que** les deuxièmes capteurs de champ magnétique (119) du deuxième sous-ensemble (126) sont disposés suivant un deuxième réseau périodique (104), **en ce que** les deuxièmes capteurs de champ magnétique (119) sont disposés suivant le deuxième réseau périodique (104) le long de la première direction (111) et le long de la deuxième direction (112), **en ce que** des deuxièmes capteurs de champ magnétiques adjacents (119) du deuxième sous-ensemble (126) sont disposés dans la première direction (111) à une première distance (113) les uns des autres, **en ce que** des deuxièmes capteurs de champ magnétique adjacents (119) du deuxième sous-ensemble (126) sont disposés dans la deuxième direction (112) à une deuxième distance (114) les uns des autres, **en ce que** le premier sous-ensemble (125) et le deuxième sous-ensemble (126) sont disposés de manière décalée l'un par rapport à l'autre d'un vecteur (120), **en ce que** le vecteur (120) comporte une première composante (121) dans la première direction (111) et une deuxième composante (122) dans la deuxième direction (112), **en ce que** la première composante (121) est inférieure à la première distance (113), **en ce que** la deuxième composante (122) est inférieure à la deuxième distance (114), **en ce que** le rotor (40) comporte une première unité d'aimants (41), **en ce que** la première unité d'aimants (41) comporte un premier ensemble périodique d'aimants pourvu d'une première longueur de période (49), **en ce que** le premier ensemble périodique d'aimants est périodique dans la première direction (111), **en ce que** la première unité d'aimants (41) est orientée dans la première direction (111) pendant le fonctionnement du système d'entraînement planaire (1), **en ce que** le rotor (40) comporte une deuxième unité d'aimants (51), **en ce que** la deuxième unité d'aimants (51) comporte un deuxième ensemble périodique d'aimants ayant une deuxième longueur de période (59), **en ce que** le deuxième ensemble périodique d'aimants est périodique dans la deuxième direction (112), **en ce que** la deuxième unité d'aimants (51) est orientée dans la deuxième direction (112) pendant le fonctionnement du système d'entraînement planaire (1), **en ce que** la première composante (121) est inférieure à la première longueur de période (49), **en ce qu'**une différence entre la première distance (113) et la première composante (121) est inférieure à la première longueur de période (49), **en ce que** la deuxième composante (122) est inférieure à la deuxième longueur de période (59), **en ce qu'**une différence entre la deuxième distance (114) et la deuxième composante (122) est inférieure à la deuxième longueur de période (59), **en ce que** l'unité de stator (14) est disposée sur un côté supérieur du boîtier de module de stator (12), **en ce que** le support (102) est disposé au-dessous de l'unité de stator (14) dans le boîtier de module de stator (12), **en ce que** le support (102) comporte une ouverture traversante (130), **en ce que** le boîtier de module de stator (12) comporte une structure thermoconductrice (34), **en ce que** la structure thermoconductrice (34) est conçue pour conduire de la chaleur de l'unité de stator (14) à un côté inférieur (33) du boîtier de module de stator (12) qui opposé à la surface de stator (11), **en ce que** la structure thermoconductrice (34) est guidée de l'unité de stator (14) au côté inférieur (33) du boîtier de module de stator (12) en passant par l'ouverture (130), **en ce que** l'ouverture traversante (130) est adjacente à quatre capteurs de champ magnétique (101), **en ce que** deux des premiers capteurs de champ magnétique (118) sont associés au premier sous-ensemble (125) et deux des deuxièmes capteurs de champ magnétique (119) sont associés au deuxième sous-ensemble (126).

2. Système d'entraînement planaire (1) selon la revendication 1, la première longueur de période (49) étant un produit d'un premier nombre rationnel et de la première distance (113), la deuxième longueur de période (59) étant un produit d'un deuxième nombre rationnel et de la deuxième distance (114) et le premier nombre rationnel et le deuxième nombre rationnel étant compris entre 0,5 et 1.

3. Système d'entraînement planaire (1) selon la revendication 2, le premier nombre rationnel étant cinq sixièmes et le deuxième nombre rationnel étant cinq sixièmes.

4. Système d'entraînement planaire (1) selon l'une des revendications 1 à 3, la première composante (121) correspondant à la moitié de la première distance (113), et la deuxième composante (122) correspondant à la moitié de la deuxième distance (114).

5. Système d'entraînement planaire (1) selon l'une des revendications 1 à 4, la première distance (113) et la deuxième distance (114) étant égales.

6. Système d'entraînement planaire (1) selon l'une des revendications 1 à 5, la première direction (111) et la deuxième direction (112) étant perpendiculaires l'une à l'autre.

7. Système d'entraînement planaire (1) selon l'une des revendications 1 à 6, la surface de stator (11) étant un parallélogramme, une longueur d'un premier côté de parallélogramme de la surface de stator (11) étant un premier multiple entier de la première distance (113), une longueur d'un deuxième côté de parallélogramme de la surface de stator (11) étant un deuxième multiple entier de la deuxième distance (114), le premier côté de parallélogramme étant orienté parallèlement à la première direction (111) et le deuxième côté de parallélogramme étant orienté parallèlement à la deuxième direction (112).

8. Système d'entraînement planaire (1) selon la revendication 7, le premier multiple entier et le deuxième multiple entier étant identiques.

9. Système d'entraînement planaire (1) selon l'une des revendications 7 et 8, le support (102) étant disposé de telle sorte qu'un premier capteur de champ magnétique d'angle (141) du premier sous-ensemble (125) soit disposé au-dessous d'une première région d'angle (25) de la surface de stator (11), la première région d'angle (25) de la surface de stator (11) étant disposée à une intersection de premier côté de parallélogramme et de deuxième côté de parallélogramme, le premier capteur de champ magnétique d'angle (141) étant placé à distance du deuxième côté parallélogramme de la surface de stator (11) dans la première direction (111) à un quart de la première distance (113), le premier capteur de champ magnétique d'angle (141) étant placé à distance du premier côté parallélogramme de la surface de stator (11) dans la deuxième direction (112) à un quart de la deuxième distance (114), un deuxième capteur de champ magnétique d'angle (142) du deuxième sous-ensemble (126) étant disposé dans une deuxième région d'angle (26) de la surface de stator (11) qui est opposée à la première région d'angle (25), la deuxième région d'angle (26) de la surface de stator (11) étant disposée à une intersection d'un troisième côté de parallélogramme et d'un quatrième côté de parallélogramme, le deuxième capteur de champ magnétique d'angle (142) étant placé à distance du quatrième côté de parallélogramme de la surface de stator (11) dans la première direction (111) à un quart de la première distance (113), le quatrième côté de parallélogramme étant opposé au deuxième côté de parallélogramme, le deuxième capteur de champ magnétique d'angle (142) étant placé à distance du troisième côté de parallélogramme de la surface de stator (11) dans la deuxième direction (112) à un quart de la deuxième distance (114), le troisième côté de parallélogramme étant opposé au premier côté de parallélogramme.

10. Module de stator (10) destiné à un système d'entraînement planaire (1) et comprenant un boîtier de module de stator (12) et une unité de stator (14) destinée à un entraînement électrique d'un rotor (40) et un module de capteur (100) destiné à détecter une position du rotor (40), le rotor (40) pouvant être entraîné au-dessus d'une surface de stator plane (11) de l'unité de stator (14) au moins dans une première direction (111) et une deuxième direction (112), le module de capteur (100) comportant un support (102) et un ensemble bidimensionnel de capteurs de champ magnétique (101), les capteurs de champ magnétique (101) étant disposés sur le support (102),
**caractérisé en ce que**
l'ensemble bidimensionnel de capteurs de champ magnétique (101) comporte un premier sous-ensemble (126) de premiers capteurs de champ magnétique (118), **en ce que** les premiers capteurs de champ magnétique (118) du premier sous-ensemble (125) sont disposés suivant un premier réseau périodique (103), **en ce que** les premiers capteurs de champ magnétique (118) du premier réseau périodique (103) sont disposés le long de la première direction (111) et le long de la deuxième direction (112), **en ce que** des premiers capteurs de champ magnétique (118) adjacents du premier sous-ensemble (125) sont disposés dans la première direction (111) à une première distance (113) les uns des autres, **en ce que** des premiers capteurs de champ magnétique adjacents (118) du premier sous-ensemble sont disposés dans la deuxième direction (112) à une deuxième distance (114) les uns des autres, **en ce que** l'ensemble bidimensionnel de capteurs de champ magnétique (101) comporte un deuxième sous-ensemble (126) de deuxièmes capteurs de champ magnétique (119), **en ce que** les deuxièmes capteurs de champ magnétique (119) du deuxième sous-ensemble (126) sont disposés suivant un deuxième réseau périodique (104), **en ce que** les deuxièmes capteurs de champ magnétique (119) sont disposés suivant le deuxième réseau périodique (104) le long de la première direction (111) et le long de la deuxième direction (112), **en ce que** des deuxièmes capteurs de champ magnétiques adjacents (119) du deuxième sous-ensemble (126) sont disposés dans la première direction (111) à une première distance (113) les uns des autres, **en ce que** des deuxièmes capteurs de champ magnétique adjacents (119) du deuxième sous-ensemble (126) sont disposés dans la deuxième direction (112) à une deuxième distance (114) les uns des autres, **en ce que** le premier sous-ensemble (125) et le deuxième sous-ensemble (126) sont disposés de manière décalée l'un par rapport à l'autre d'un vecteur, **en ce que** le vecteur comporte une première composante (121) dans la première direction (111) et une deuxième composante (122) dans la deuxième direction (112), **en ce que** la première composante (121) est inférieure à la première distance (113), **en ce que** la deuxième composante (122) est inférieure à la deuxième distance (114), **en ce que** l'unité de stator (14) est disposée sur un côté supérieur du boîtier de module de stator (12), **en ce que** le support (102) est disposé au-dessous de l'unité de stator (14) dans le boîtier de module de stator (12), **en ce que** le support (102) comporte une ouverture traversante (130), **en ce que** le boîtier de module de stator (12) comporte une structure thermoconductrice (34), **en ce que** la structure thermoconductrice (34) est conçue pour conduire de la chaleur de l'unité de stator (14) à un côté inférieur (33) du boîtier de module de stator (12) qui opposé à la surface de stator (11), **en ce que** la structure thermoconductrice (34) est guidée de l'unité de stator (14) au côté inférieur (33) du boîtier de module de stator (12) en passant par l'ouverture (130), **en ce que** l'ouverture traversante (130) est adjacente à quatre capteurs de champ magnétique (101), **en ce que** deux des premiers capteurs de champ magnétique (118) sont associés au premier sous-ensemble (125) et deux des deuxièmes capteurs de champ magnétique (119) sont associés au deuxième sous-ensemble (126).

11. Module de stator (10) selon la revendication 10, le support (102) comportant une plaquette de conducteurs, en particulier une carte de circuit imprimé.

12. Module de stator (10) selon l'une des revendications 10 et 11, le support (102) comportant une pluralité d'ouvertures traversantes (130) et une pluralité d'éléments thermoconducteurs (34) guidés à travers les ouvertures traversantes (130), chacune des ouvertures traversantes (130) étant adjacente à quatre capteurs de champ magnétique (101), deux des premiers capteurs de champ magnétique (118) étant associés au premier sous-ensemble (125) et deux des deuxièmes capteurs de champ magnétique (119) étant associés au deuxième sous-ensemble (126).

13. Module de stator (10) selon l'une des revendications 10 à 12, le support (102) comportant une région intérieure (108) et une région extérieure (107), la région extérieure (107) étant disposée annulairement autour de la région intérieure (108), l'ouverture traversante (130) ou les ouvertures traversantes (130) étant disposées dans la région extérieure (107), la région extérieure (107) comprenant au moins 50 pour cent d'une surface du module de capteur (100).

14. Module de stator (10) selon l'une des revendications 10 à 13, l'ensemble de capteurs de champ magnétique (101) comprenant exactement deux sous-ensembles (125, 126) de capteurs de champ magnétique (101) .

15. Module de capteur (100) destiné à détecter une position d'un rotor (40) dans un système d'entraînement planaire (1), le module de capteur (100) comportant un support (102) et un ensemble bidimensionnel de capteurs de champ magnétique (101), les capteurs de champ magnétique (101) étant disposés sur le support (102), l'ensemble bidimensionnel de capteurs de champ magnétique (101) comportant un premier sous-ensemble (125) de premiers capteurs de champ magnétique (118), les premiers capteurs de champ magnétique (118) du premier sous-ensemble (125) étant disposés suivant un premier réseau périodique (103), les premiers capteurs de champ magnétique (118) étant disposés suivant le premier réseau périodique (103) dans une première direction (111) et dans une deuxième direction (112), des premiers capteurs de champ magnétique adjacents (118) du premier sous-ensemble (125) étant disposés le long de la première direction (111) à une première distance (113) les uns des autres, des premiers capteurs de champ magnétique adjacents (118) du premier sous-ensemble (125) étant disposés le long de la deuxième direction (112) à une deuxième distance (114) les uns des autres,
**caractérisé en ce que**
l'ensemble bidimensionnel de capteurs de champ magnétique (101) comporte un deuxième sous-ensemble (126) de deuxièmes capteurs de champ magnétique (119), **en ce que** les deuxièmes capteurs de champ magnétique (119) du deuxième sous-ensemble (126) sont disposés suivant un deuxième réseau périodique (104), **en ce que** les deuxièmes capteurs de champ magnétique (119) sont disposés suivant le deuxième réseau périodique (104) dans la première direction (111) et dans la deuxième direction (112), **en ce que** des deuxièmes capteurs de champ magnétique adjacents (119) du deuxième sous-ensemble (126) sont disposés le long de la première direction (111) à la première distance (113) les uns des autres, **en ce que** des deuxièmes capteurs de champ magnétique adjacents (119) du deuxième sous-ensemble (126) sont disposés le long de la deuxième direction (112) à une deuxième distance (114) les uns des autres, **en ce que** le premier sous-ensemble (125) et le deuxième sous-ensemble (126) sont disposés de manière décalée l'un par rapport à l'autre d'un vecteur, **en ce que** le vecteur comporte une première composante (121) dans la première direction (111) et une deuxième composante (122) dans la deuxième direction (112), **en ce que** la première composante (121) est inférieure à la première distance (113) et **en ce que** la deuxième composante (122) est inférieure à la deuxième distance (114), **en ce que** le support (102) comporte une ouverture traversante (130) destinée à une structure thermoconductrice (34), **en ce que** l'ouverture traversante (130) est adjacente à quatre capteurs de champ magnétique (101), **en ce que** deux des premiers capteurs de champ magnétique (118) sont associés au premier sous-ensemble (125) et deux des deuxièmes capteurs de champ magnétique (119) sont associés au deuxième sous-ensemble (126).
